(19) Europäisches Patentamt
European Patent Office
Office européen des brevets

(11) **EP 1 927 012 B1**

(12) **EUROPÄISCHE PATENTSCHRIFT**

(45) Veröffentlichungstag und Bekanntmachung des Hinweises auf die Patenterteilung:
**28.01.2015 Patentblatt 2015/05**

(21) Anmeldenummer: **06791941.5**

(22) Anmeldetag: **08.09.2006**

(51) Int Cl.:
**G01R 33/60** *(2006.01)* **G01N 24/10** *(2006.01)*

(86) Internationale Anmeldenummer:
**PCT/EP2006/008784**

(87) Internationale Veröffentlichungsnummer:
**WO 2007/028635 (15.03.2007 Gazette 2007/11)**

(54) **VERFAHREN ZUR BESTIMMUNG DES ENDOGENEN ANTIOXIDATIVEN POTENTIALS VON GETRÄNKEN MITTELS ESR-SPEKTROSKOPIE**

METHOD FOR DETERMINING THE ENDOGENOUS ANTIOXIDATIVE POTENTIAL OF BEVERAGES BY MEANS OF ESR SPECTROSCOPY

PROCEDE POUR DETERMINER LE POTENTIEL ANTIOXYDANT ENDOGENE DE BOISSONS PAR SPECTROSCOPIE ESR

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **10.09.2005 DE 102005043113**

(43) Veröffentlichungstag der Anmeldung:
**04.06.2008 Patentblatt 2008/23**

(73) Patentinhaber:
• **Technische Universität Berlin**
**10623 Berlin (DE)**
• **Universität des Saarlandes**
**66123 Saarbrücken (DE)**

(72) Erfinder:
• **KUNZ, Thomas**
**54295 Trier (DE)**
• **METHNER, Frank-Jürgen**
**54634 Bitburg (DE)**
• **HÜTTERMANN, Jürgen**
**66424 Homburg (DE)**
• **KAPPL, Reinhard**
**66424 Homburg (DE)**

(74) Vertreter: **Engelhard, Markus**
**Boehmert & Boehmert**
**Anwaltspartnerschaft mbB**
**Patentanwälte Rechtsanwälte**
**Pettenkoferstrasse 20-22**
**80336 München (DE)**

(56) Entgegenhaltungen:
**EP-A2- 0 720 026 WO-A-2005/003759**

• **ANDERSEN M L ET AL: "Modification of the Levels of Polyphenols in Wort and Beer by Addition of Hexamethylenetetramine or Sulfite during Mashing" JOURNAL OF AGRICULTURAL AND FOOD CHEMISTRY, AMERICAN CHEMICAL SOCIETY. WASHINGTON, US, Bd. 49, 23. Oktober 2001 (2001-10-23), Seiten 5232-5237, XP002362412 ISSN: 0021-8561**
• **KUNZ T ET AL: "Fundamentals on electron spin resonance spectrosopy (ESR) and research about the correlation between oxidative beer stability and sulphite content." MONATSSCHRIFT FUER BRAUWISSENSCHAFT 55 (7/8) 140-153 2002 INST. FUER BIOPHYSIK, FR2.5, UNIKLINIKUM DES SAARLANDES, 66421 HOMBURG, GERMANY, 2002, XP009075447 in der Anmeldung erwähnt**
• **PASCUAL E C ET AL: "Characterization of free radicals in soluble coffee by electron paramagnetic resonance spectroscopy." JOURNAL OF AGRICULTURAL AND FOOD CHEMISTRY 50 (21) 6114-6122 2002 CORRESPONDENCE (REPRINT) ADDRESS, B. A. GOODMAN, SCOTTISH CROP RES. INST., INVERGOWRIE, DUNDEE DD2 5DA, UK. TEL. 44 1382 568532. FAX 44 1382 562426. E-MAIL BGOODM(A)SCRI.SARI.AC.UK, 9. Oktober 2002 (2002-10-09), XP002409269**

- KOCHERGINSKY N M ET AL: "Antioxidant pool in beer and kinetics of EPR spin-trapping." JOURNAL OF AGRICULTURAL AND FOOD CHEMISTRY 53 (17) 6870-6876 2005 DEP. OF CHEM. & BIOMOLECULAR ENG., NAT. UNIV. OF SINGAPORE, SINGAPORE 119260, SINGAPORE. E-MAIL NMKOCH(A)YAHOO.COM, 24. August 2005 (2005-08-24), XP002409270

- ANDERSEN M L ET AL: "Potential antioxidants in beer assessed by ESR spin trapping." JOURNAL OF AGRICULTURAL AND FOOD CHEMISTRY 48 (8) 3106-3111 2000 FOOD CHEM., DEP. OF DAIRY & FOOD SCI., ROYAL VET. & AGRIC. UNIV., DK-1958 FREDERIKSBERG C, DENMARK. TEL. +4535283262. FAX +4535283344. E-MAIL MOLA (A)KVL.DK, August 2000 (2000-08), XP002409271

**Beschreibung**

Die vorliegende Erfindung betrifft ein Verfahren zur Bestimmung des endogenen anitoxidativen Potentials (EAP) in einer Getränkeprobe, vorzugsweise Bier, Wein, Saft oder Mischungen davon, unter Anwendung der ESR-Spektroskopie. Genauer gesagt, betrifft die vorliegende Erfindung ein Verfahren zur Messung eines durch ein Spin-Trap-Reagenz stabilisierten sekundären Radikals, vorzugsweise eines Hydroxyethylradikals, wobei das Spin-Trap-Reagenz N-*tert*-Butyl-$\alpha$-(4-pyridyl)nitron-N-oxid (POBN) ist. Die Erfindung betrifft weiterhin eine Verwendung des Verfahrens zur Beurteilung der oxidativen Stabilität einer Getränkeprobe.

Hintergrund der Erfindung

Aussehen und Aroma sind die hauptsächlichen Kriterien, nach denen ein Verbraucher ein Bier, aber auch andere Getränke wie etwa Wein, Saft oder Mixgetränke, beurteilt. Deshalb sollte das so genannte "Flavour", das aus dem Zusammenwirken gustatorischer und olfaktorischer Sinneseindrücke resultiert, über den gesamten Zeitraum der angegebenen Mindesthaltbarkeit möglichst konstant bleiben. Dem wirkt jedoch der natürliche Alterungsvorgang eines Getränks, vorzugsweise eines Bieres, entgegen. Aus diesem Grund nimmt die Geschmacksstabilität als ein wichtiges Qualitätsmerkmal von Bier einen immer höheren Stellenwert ein.

Die oxidative Geschmacksstabilität ist im Wesentlichen davon abhängig, in welchem Ausmaß ein Bier in der Lage ist, die Bildung von primären Sauerstoffradikalen ($O_2^-\bullet$; $OH\bullet$; $H\bullet$; $HO_2\bullet$) zu behindern und wird entsprechend durch das auf reduzierenden Verbindungen, wie etwa Schwefeldioxid ($SO_2$), Maillard-Reaktionsprodukten, Ascorbinsäure und phenolischen Inhaltsstoffen, basierende endogene antioxidative Potenzial (EAP) eines Bieres beeinflusst.

Die im Laufe der Bieralterung entstehenden Radikale werden meist über verschiedene For-men von aktiviertem Sauerstoff initiiert, dem damit eine besondere Rolle bei der Entstehung des Alterungsgeschmacks zukommt. Bei den primären Sauerstoffradikalen ist insbesondere auf das über die Fenton- und Haber-Weiss-Reaktion entstehende Hydroxylradikal hinzuweisen, welches bei der Bieralterung eine Schlüsselposition einnimmt. Kann die Entstehung von Hydroxylradikalen vermindert oder sogar verhindert werden, so wird das Auftreten des Alterungsgeschmacks verzögert, zu dessen Ausbildung maßgeblich Carbonylverbindungen, und unter diesen insbesondere aliphatische Aldehyde, beitragen [5, 6, 14, 15].

Biere sind in der Lage, die Bildung von Hydroxylradikalen über einen bestimmten Zeitraum zu behindern, bevor die Radikalgenerierung ungehindert abläuft. Bei gleichen äußeren Bedingungen (z.B. Temperatur, Sauerstoffkontakt etc.) und bei gleich bleibenden Verhältnissen in einer Bierprobe (z.B. pH-Wert, gelöster Sauerstoff etc.) steht der Zeitraum der Behinderung bzw. Verzögerung der Radikalgenerierung in einem direkten Bezug zum vorliegenden EAP.

Mit dem Ziel, eine Aussage über die zu erwartende Geschmacksstabilität eines Bieres treffen zu können, wird seit einigen Jahren die Elektronen-Spin-Resonanz- (ESR-) Spektroskopie eingesetzt. Dabei wird über eine experimentell beschleunigte ("forcierte") Bieralterung bei erhöhten Temperaturen ("Forciertest", üblicherweise bei 60 °C) die so genannte "Lag-Time" eines Bieres bestimmt. Der Lag-Time-Wert entspricht demjenigen Zeitpunkt, ab dem die Radikalgenerierung im Bier unter definierten experimentellen Bedingungen ungehindert abläuft, und der über diese Messmethode ermittelte Wert der Lag-Time wird als ein Kriterium für das EAP des Bieres betrachtet [1-11].

Bei diesem Messverfahren, das zuerst von Kaneda *et al.* [12] beschrieben und von Uchida et *al.* [1] weiterentwickelt wurde, wird die Eigenschaft der ESR-Spektroskopie ausgenutzt, um in dem komplexen System Bier mit einer Vielzahl von verschiedensten Inhaltsstoffen selektiv Radikale mit hoher Empfindlichkeit nachzuweisen. Da Radikale in wässrigen Lösungen meist nur eine sehr kurze Lebendauer haben, ist es dabei erforderlich, einen Radikalfänger ("Spin-Trap") einzusetzen, der diffusible Radikale anlagern kann. Bei dem von Uchida *et al.* [1] gewählten Spin-Trap-Reagez N-*tert*-Butyl-$\alpha$-phenylnitron (PBN) entsteht ein weitaus stabileres Nitroxid-Radikal, das in ausreichendem Maße zeitlich akkumuliert wird und so mit der ESR-Spektroskopie anhand seiner spektralen Charakteristika nachgewiesen werden kann [13].

Der Mechanismus der Lag-Time-Messung nach dem bekannten Verfahren wurde so interpretiert, dass es die für die oxidative Bieralterung wichtigen Hydroxylradiale sind, deren zeitabhängige Bildung mit dem dem Spin-Trap-Reagenz PBN im Verlauf des Forciertest erfasst wird.

Neben den ESR-Spektrometem in Forschungseinrichtungen wird von der Firma Bruker (Karlsruhe) ein Tischgerät mit der Bezeichnung "e-scan" (kleines X-Band-ESR-Spektrometer) angeboten, mit dem sich die Lag-Time unter Anwendung des oben beschriebenen Verfahrens in den Laboren der Getränke produzierenden Industrie ermitteln lässt.

Das beschriebene Verfahren weist jedoch signifikante Schwächen und Verfälschungen auf. In diesem Zusammenhang ist insbesondere auf einen durch das verwendete Spin-Trap-Reagenz PBN verursachten pH-Wert-Effekt hinzuweisen. Dieser Effekt führt dazu, dass der pH-Wert einer Bierprobe in Abhängigkeit von der eingesetzten PBN-Konzentration während der Lag-Time-Messung ansteigt. Nach Bishop *et al.* [19] und *Millero et al.* [20] führt ein pH-Wert-Anstieg, insbesondere im pH-Wert-Bereich > 4,5 (Fenton-Reaktion), zu einer starken Beschleunigung der Hydroxylradikalgenerierung.

Der von der PBN-Konzentration abhängige pH-Wert-Anstieg (pH-Wert-Effekt) während der Lag-Time-Messung beschleunig die Radikalgenerierung im Bier, und das vorhandene EAP wird im Zeitverlauf der Lag-Time-Messung immer schneller verbraucht. Der Zeitpunkt der ungehinderten Radikalgenerierung (gemessene Lag-Time) weicht entsprechend stark von den im Bier eigentlich vorliegenden Verhältnissen ab. Allein aus diesem Grund ist die Lag-Time-Messung nach bisheriger Vorgehensweise nicht ohne Weiteres geeignet, das EAP eines Bieres korrekt wiederzugeben.

Erschwerend kommt hinzu, dass das durch die PBN-Zugabe verursachte Ausmaß der Verfälschung für den Zeitpunkt der ungehinderten Radikalgenerierung (pH-Wert-Effekt) zusätzlich vom vorhandenen EAP eines Bieres beeinflusst wird. Dies lässt sich darüber erklären, dass der pH-Wert-Einfluss auf die Radikalgenerierung innerhalb der Lag-Time für Biere mit unterschiedlichen EAPs verschieden ist. Dadurch wird die Radikalgenerierung innerhalb einer hohen Lag-Time länger und stärker - da höhere pH-Werte erreicht werden - in Richtung einer vermehrten Hydroxylradikalgenerierung beeinflusst, und der Abstand der gemessenen Lag-Time gegegenüber den im Bier tatsächlich vorliegenden Verhältnissen entsprechend vergrößert.

Ein weiterer Faktor der Verfälschung ergibt sich daraus, dass viele antioxidativ wirkende Inhaltstoffe (z.B. phenolische Substanzen etc.) in ihrer Wirkungsweise pH-Wert-abhängig sind. Da die Verfälschungen vielseitig sind und die Abweichungen bei Bieren mit einer mittleren bis hohen oxidativen Bierstabilität bis zu 600% betragen, lässt sich für viele bzw. die meisten Biere kein Zusammenhang mehr zum EAP herstellen. Die Lag-Time-Messung nach bisheriger Vorgehensweise ist zur Bestimmung des EAPs der Biere ungeeignet, und die resultierenden Ergebnisse führten in jüngerer Zeit zu entsprechenden Fehlinterpretationen in verschiedenen Publikationen. Nicht nur die Einflüsse der Bierinhaltsstoffe auf die oxidative Bierstabilität werden stark verfälscht wiedergegeben, sondern es werden auch die auf diesen Messungen beruhenden brautechnischen Maßnahmen zur Verbesserung der oxidativen Bierstabilität aufgrund der Ergebnisse falsch eingeschätzt.

Der Artikel Andeisen M.L. et al J. Agric. Food chem. 2001, 49, 5232-5237, beschreibt ein Verfahren zur Bestimmung eines endogenen antioxidativen Potentials in eine, Proben, umfassend die quantitative Analyse eines mit POBN stabilisierten sekundären Kadikals.

Im Stand der Technik [16, 17] gibt es außerdem Hinweise darauf, dass es sich bei den mit PBN detektierten Radikalen in der Hauptsache gar nicht um Hydroxylradikale selbst handelt, sondern dass die aus einer Folgereaktion des Hydroxylradikals mit dem Ethanol des Bieres entstandenen Hydroxyethylradikale über das bisher angenommene Maß von wenigen Prozent an der gemessenen Signalintensität beteiligt sind. Dies wurde mit einer höheren Stabilität der stabilisierten Hydroxyethyl-PBN-Spin-Addukte begründet [17]. Die Frage, welche Radikale letztendlich bei der Lag-Time-Bestimmung eine Rolle spielen, ist nicht nur hinsichtlich des Verfahrens selbst von besonderem Interesse, sondern kann vor allem bei der weiteren Klärung der noch nicht vollständig bekannten Alterungsprozesse hilfreich sein.

Es besteht folglich ein Bedarf an einem verbesserten Verfahren zur Beurteilung der Geschmacksstabilität von Bier und anderen oxidativen Getränken.

Eine Aufgabe der vorliegenden Erfindung war es deshalb, ein Verfahren verfügbar zu machen, mit dem sich das EAP von Bier und anderen Getränken zuverlässiger als bisher bestimmen lässt.

Kurzfassung der **Erfindung**

Diese Aufgabe wird durch die Erfindung, wie in den Patentansprüchen beansprucht, gelöst.

Die Aufgabe der vorliegenden Erfindung wird gelöst durch ein Verfahren zur Bestimmung eines EAPs in einer Probe, umfassend die qualitative und/oder quantitative Analyse eines mit dem Spin-Trap-Reagenz POBN stabilisierten sekundären Radikals unter Verwendung von ESR-Spektroskopie, wobei das Spin-Trap-Reagenz geeignet ist, die Umgehung des pH-Wert-Effekts und des damit verbundenen Einflusses auf die Radikalgenerierung in der Probe zu erlauben.

Erfindungsgemäß ist die Probe eine Getränkeprobe, ausgewählt aus der Gruppe, bestehend aus einer Probe von Bier, Wein, Saft und Mischungen davon.

In einer bevorzugten Ausführung ist die Probe eine Bierprobe.

Erfindungsgemäß ist das Spin-Trap-Reagenzes POBN.

Erfindungsgemäß beträgt die Konzentration des Spin-Trap-Reagenzes in der Probe ungefähr ≤ 10 mM.

In einer bevorzugten Ausführung beträgt die Konzentration des Spin-Trap-Reagenzes in der Probe ungefähr 3 mM.

In einer Ausführung ist das Spin-Trap-Reagenz in der Probe lösbar und wird vorzugsweise in der Probe gelöst.

In einer alternativen Ausführung wird das Spin-Trap-Reagenz vor Zugabe zu der Probe in einer wässrigen Ethanollösung oder einer anderen wässrigen Lösung gelöst.

In einer Ausführung ist das sekundäre Radikal ein Hydroxyethylradikal.

In einer Ausführung umfasst das Verfahren folgende Schritte:

(a) Bereitstellen der Probe;
(b) Hinzufügen des Spin-Trap-Reagenzes;

(c) Durchführen der Analyse;
(d) Bestimmung des EAP-Werts.

In einer bevorzugten Ausführung umfasst das Durchführen der Analyse in Schritt (c) das Durchführen eines Forciertest.

In einer besonders bevorzugten Ausführung wird der Forciertest bei einer Temperatur im Bereich von ungefähr ≥ 40 °C bis ungefähr ≤ 96 °C durchgeführt.

In einer weiteren besonders bevorzugten Ausführung wird der Forciertest bei einer Temperatur im Bereich von ungefähr ≥ 60 °C bis ungefähr ≤ 96 °C durchgeführt.

In einer weiteren besonders bevorzugten Ausführung wird der Forciertest bei einer Temperatur im Bereich von ungefähr 63-65 °C bei Bier als Probe, ungefähr 65-70 °C bei Wein als Probe und ungefähr 60 °C bei Saft als Probe durchgeführt.

In einer weiteren besonders bevorzugen Ausführung wird der Forciertest bei einer Temperatur von ungefähr 63 °C durchgeführt.

Dabei wird der Forciertest bei einem pH-Wert durchgeführt, der in einem Bereich liegt, der sich von ungefähr einem pH-Wert-Punkt unterhalb bis zu ungefähr einem pH-Wert-Punkt oberhalb des pH-Werts der Probe erstreckt.

In einer bevorzugten Ausführung wird der Forciertest bei einem pH-Wert durchgeführt, der in einem Bereich liegt, der sich von ungefähr 0,5 pH-Wert-Punkten unterhalb bis zu ungefähr 0,5 pH-Wert-Punkten oberhalb des pH-Werts der Probe erstreckt.

In einer besonders bevorzugten Ausführung wird der Forciertest bei einem pH-Wert durchgeführt, der ungefähr dem pH-Wert der Probe entspricht.

In einer weiteren besonders bevorzugten Ausführung wird der Forciertest in Gegenwart von Ethanol im Bereich von ungefähr 0,01-20 Vol.-% durchgeführt.

In einer weiteren besonders bevorzugten Ausführung wird der Forciertest in Gegenwart von Ethanol im Bereich von ungefähr 0,01-10 Vol.-% durchgeführt.

In einer weiteren besonders bevorzugten Ausführung wird der Forciertest in Gegenwart von Ethanol im Bereich von ungefähr 0,01-6,0 Vol.-% durchgeführt.

In einer weiteren besonders bevorzugten Ausführung wird der Forciertest in Gegenwart von Ethanol im Bereich von 0,01-3,0 Vol.% durchgeführt.

In einer bevorzugten Ausführung umfasst das Durchführen der Analyse in Schritt (c) des Verfahrens folgende Teilschritte:

(c1) Entnahme einer Messprobe zu einer bestimmten Zeit;
(c2) Aufnahme des ESR-Spektrums der Messprobe.

In einer besonders bevorzugten Ausführung beträgt der Zeitraum zwischen den Teilschritten (c1) und (c2) ungefähr ≤ 15 min.

In einer weiteren besonders bevorzugten Ausführung beträgt der Zeitraum zwischen den Teilschritten (c1) und (c2) ungefähr 4 min.

In einer Ausführung umfasst das Verfahren ein die Radikalgenerierung förderndes System, wobei das die Radikalgenerierung fördernde System ein Fenton-System oder ein Röntgen-System ist, wie hierin beschrieben.

In einer Ausführung umfasst das Verfahren die qualitative und/oder quantitative Analyse des Einflusses einer oxidativ neutralen, antioxidativen oder oxidativen Verbindung auf das EAP der Probe, wobei die Verbindung ausgewählt ist aus der Gruppe, bestehend aus Sauerstoff, $SO_2$, Maillard-Reaktionsprodukten, Ascorbinsäure (Vitamin C) und anderen Vitaminen wie etwa Vitamin B oder Vitamin A, Metallionen, wie etwa $Fe^{2+}$ oder $Cu^+$, phenolischen Verbindungen, wie etwa Phenolcarbonsäuren oder Flavonoiden, organischen Säuren, Proteinen, Polypeptiden, Aminosäuren, Alkoholen, wie etwa Ethanol, und Salzen, wie etwa $CaCl_2$.

In einer bevorzugten Ausführung ist die antioxidative Verbindung $SO_2$.

In einer bevorzugten Ausführung ist die antioxidative Verbindung Ascorbinsäure.

In einer bevorzugten Ausführung ist die oxidative Verbindung Sauerstoff.

In einer bevorzugten Ausführung ist die Phenolcarbonsäure Gallussäure.

In einer Ausführung wird der Probe $SO_2$ zudotiert, und es wird ein Quotient $BAX_{(sp)}$ aus dem Anstieg des EAPs in der Probe und dem Probengehalt an $SO_2$ nach der folgenden Formel bestimmt:

$$BAX_{(sp)} = \Delta \, EAP / \Delta \, SO_2\text{-Gehalt}_{(sp)} \, [\min \cdot l/mg]$$

wobei Δ EAP der EAP-Wert nach $SO_2$-Zudotierung minus EAP-Wert vor $SO_2$-Zudotierung ist, und
wobei Δ $SO_2$-Gehalt der durch Zudotierung hervorgerufene $SO_2$-Gehalt ist.

In einer alternativen Ausführung wird ein Quotient BAX aus dem Gesamt-EAP in der Probe und dem Gesamtgehalt an $SO_2$ in der Probe nach der folgenden Formel bestimmt:

$$BAX = EAP_{(gesamt)}/SO_2\text{-Gehalt}_{(gesamt)} \ [min \cdot l/mg]$$

Die Aufgabe der vorliegenden Erfindung wird weiterhin gelöst durch eine Verwendung des Verfahrens der vorliegenden Erfindung zur Beurteilung der oxidativen Stabilität einer Getränkeprobe.

Die vorliegende Erfindung ermoglicht die Verwendung eines Spin-Trap-Reagenzes zur qualitativen und/oder quantitativen Analyse eines stabilisierten sekundären Radikals in einer Probe unter Verwendung von ESR-Spektroskopie, wobei das Spin-Trap-Reagenz geeignet ist, die Umgehung des pH-Wert-Effekts und des damit verbundenen Einflusses auf die Radikalgenerierung in der Probe zu erlauben.

Der Begriff "endogenes antioxidatives Potential" oder "EAP" beschreibt das antioxidative Verhalten einer Probe und basiert im Wesentlichen auf der Gesamtheit aller in einer Probe vorhandenen antioxidativ wirkenden Verbindungen ($SO_2$, Maillard-Reaktionsprodukte, Ascorbinsäure, phenolische Inhaltsstoffe etc.)

Der Begriff "Spin-Trap-Reagenz" bedeutet einen Radikalfänger, der kurzlebige Radikale stabilisiert. In Betracht kommen werden alle Spin-Trap-Reagenzien, mit denen es möglich ist, die Verfälschung der Ergebnisse nach der bisherigen Vorgehensweise der Lag-Time-Messung, insbesondere den pH-Wert-Effekt auf die Radikalgenerierung in Abhängigkeit von der PBN-Konzentration, zu umgehen oder zu beseitigen und somit das "wahre" EAP einer Probe zu bestimmen, d.h. die geeignet sind, dafür zu sorgen, dass der Einfluss des pH-Wert-Effekts auf das stabilisierte Radikal vernachlässigbar ist.

Der Begriff "stabilisiertes sekundäres Radikal", auch "stabilisiertes Sekundärradikal" oder kurz "stabilisiertes Radikal" bedeutet, dass eine das Radikal stabilisierende Verbindung angelagert ist, z.B. ein Spin-Trap-Reagenz. Der Begriff "sekundäres Radikal" umfasst das bevorzugte Hydroxyethylradikal, aber auch solche sekundären Radikale, die sich beispielsweise von Fuselalkoholen ableiten.

Der Begriff "ESR-Spektroskopie", wie hier verwendet, betrifft die Durchführung einer ESR-Spektroskopie-Analyse, wie sie im Stand der Technik bekannt ist.

Der Begriff "Bier" umfasst alle bekannten Typen von Bier, auch alkoholfreies Bier. Weiterhin umfasst sind Vorstufen des fertigen Bieres, wie sie etwa im Laufe des Brauprozesses entstehen. Der Begriff "Wein" umfasst alle bekannten Typen von Wein, auch Apfelwein und alkoholfreie Produkte. Der Begriff "Saft" umfasst sowohl Fruchtsäfte als auch Gemüsesafte. Ebenfalls in Betracht gezogen werden Sekt, Champagner und weinhaltige Getränke. Auch für Wein und Saft gilt, dass während des Herstellungsprozesses gebildete Zwischenprodukte umfasst sein sollen. Mischungen der genannten Getränke können Mischungen mit Wasser ("Fruchtsaftgetränk") oder kohlensäurehaltigem Mineralwasser ("Schorle"), Mischungen von Bier mit Limonaden ("Radler", "Alster") oder Mischungen von Fruchtsaft mit Spirituosen ("Cocktail") sein. Grundsätzlich kommen alle Getränke in Betracht, die ein EAP aufweisen.

Die "oxidative Stabilität" bedeutet die "Getränkestabilität" oder auch "Bierstabilität", gemessen als EAP-Wert, lässt sich folgendermaßen einteilen: < 100 min niedrige Stabilität, 100-300 min mittlere Stabilität, 300-500 min hohe Stabilität, > 500 min sehr hohe Stabilität. Grundsätzlich funktioniert die EAP-Bestimmung in allen Bereichen der oxidativen Bierstabilität. Gemäß der vorliegenden Erfindung ist die oxidative Stabilität ein wesentlicher Faktor, durch den die geschmackliche Veränderung eines Getränks beeinflusst wird.

Der Begriff "Forciertest" bezeichnet eine Vorgehensweise, mit dem die Bieralterung - experimentell beschleunigt - simuliert wird.

Bezogen auf den "pH-Wert", bei dem der Forciertest durchgeführt wird, ist anzustreben, möglichst nahe an dem pH-Wert der Probe zu bleiben. Das Spin-Trap-Reagenz sollte den pH-Wert nicht oder nur in äußerst geringem Maße beeinflussen. Der pH-Wert von Bier liegt üblicherweise zwischen pH 4,1 und pH 4,5; ein zu starker pH-Wert-Anstieg führt sehr schnell in den Bereich der beschleunigten Radikalgenerierung. Für Biermixgetränke, wie beispielsweise Radler, und die meisten Säfte werden andere pH-Wert gemessen: für Radler z.B. pH 3,78, für Fruchtsaft z.B. pH 3,43, während Karottensaft einen pH-Wert von > 5 aufweist.

Die "Gegenwart von Ethanol" im Forciertest bzw. die Konzentration an Ethanol (in Vol.-%), die bei der Durchführung des Forciertests vorzugsweise vorhanden ist, hängt von der zu untersuchenden Probe ab: eine Ethanol-Konzentration im Bereich von ungefähr 0,01-20 Vol-% empfiehlt sich bei der Messung von beispielsweise Wein, 0,01-10 Vol.-% z.B. bei Starkbier oder Weinschorle, 0,01-6,0 Vol.-% z.B. bei Bier, und 0,01-3,0 Vol.-% z.B. bei Saft.

Die Formulierung "ein die Radikalgenerierung förderndes System" umfasst Systeme, wie etwa eine "Fenton-System" oder ein "Röntgen-System" (siehe auch Beispiel 1, 1.1.).

Veranlassung für die vorliegende Erfindung war der Nachweis, dass das bisher bekannte Verfahren zur Messung der Lag-Time von Bier für viele Proben ungeeignet ist, das EAP eines Getränks, vorzugsweise eines Bieres, zuverlässig zu beurteilen. Während bei Bierproben mit einer geringen oxidativen Stabilität ein direkter Bezug zum eigentlich vorliegenden EAP eingeschränkt herstellbar ist, können bei Proben, die sich durch eine mittlere bis hohe oxidative Bierstabilität auszeichnen, die Abweichungen zwischen dem gemessenen Lag-Time-Wert und den eigentlichen Verhältnissen im Bier bis zu 600 % betragen. Dies ist kein vernachlässigbarer Wert, vielmehr muss man von einer wesentlichen Beeinflussung sprechen, die für eine Analysenmethode nicht mehr zu tolerieren ist. Da die Abweichungen nicht nur von dem durch die PBN-Zugabe verursachten Einfluss auf die Radikalgenerierung (pH-Wert-Effekt) abhängig sind, sondern, wie beschrieben, in allen Lag-Time-Bereichen unterschiedlich beeinflusst werden, lässt sich für solche Biere kein Zusammenhang mehr zum EAP herstellen. Erschwerend kommt hinzu, dass viele antioxidativ wirkende Inhaltsstoffe (z.B. phenolische Substanzen, Ascorbinsäure etc.) in ihrer Wirkungsweise pH-Wert-abhängig sind.

Die vorliegende Erfindung macht ein verbessertes Verfahren zur Beurteilung der oxidativen Stabilität von Getränken, vorzugsweise Bier, verfügbar, das es ermöglicht, das eigentliche ("wahre") EAP in einer Probe durch Messung der Generierung von sekundären Radikalen, vorzugsweise Hydroxyethylradikale, nachzuweisen. Das Messverfahren setzt die ESR-Spektroskopie ein und beruht ebenso wie bisher bekannte Verfahren auf einem indirekten Nachweis der Radikale mit Hilfe eines Spin-Trap-Reagenzes. Die Radikale entstehen bevorzugt aus den radikalischen Reaktionen der primären Sauerstoffradikalspezies ($O_2^-\bullet$; $OH\bullet$; $H\bullet$; $HO_2\bullet$) mit den verschiedensten Getränkeinhaltsstoffen, insbesondere Alkoholen. Im Unterschied zum Stand der Technik jedoch setzt das erfindungsgemäße Verfahren spezielle Spin-Trap-Reagenzien ein, die ganz spezifische Eigenschaften besitzen, wobei das Spin-Trap-Reagenz vorzugsweise N-*tert*-Butyl-$\alpha$-(4-pyridyl)nitron-N-oxid (POBN) ist. Zu den für die neue EAP-Bestimmung essentiellen Eigenschaften der Spin-Trap-Reagenzien gehört im Vergleich zur bisherigen Vorgehensweise ein sehr viel höhere Affinität zu den sekundären Radikalen, insbesondere den Hydroxyethylradikalen, eine höhere Stabilität des Spin-Trap-Reagenzes und der Spin-Trap-Addukte gegenüber der bisher vorliegenden, den pH-Wert verändernden Inaktivierungsreaktion und die direkte Löslichkeit des Spin-Trap-Reagenzes in der Probe. Durch die Kombination dieser Eigenschaften mit einer gezielten Anpassung der Analysenparameter (z.B. Forciertest bei erhöhter Temperatur, Spin-Trap-Konzentration etc.) ist es möglich, das "wahre" EAP einer Probe zu bestimmen, ohne die vorliegenden Verhältnisse in einer Probe (pH-Wert, Radikalgenerierung etc.) signifikant zu verändern. Das letztendliche Kriterium für das EAP in einer Probe unter den definierten experimentellen Bedingungen bildet einen über den Zeitpunkt der ungehinderten Radikalgenerierung in der Probe ermittelten Wert (EAP-Wert).

Durch die der vorliegenden Erfindung zugrunde liegenden Forschungsarbeiten konnte unter Zuhilfenahme eines speziellen radikalgenerierenden Aufbaus (Fenton-System) und durch Bestrahlungsversuche (Röntgenstrahlung zur Radikalerzeugung) eindeutig nachgewiesen werden, dass bei der Lag-Time-Messung nur im geringfügigen Maße Hydroxylradikale direkt nachgewiesen werden. Vielmehr wird die Signalintensität der ESR-Spektren hauptsächlich durch das sekundäre Hydroxyethylradikal verursacht, das offensichtlich wesentlich stabilere PBN-Spin-Addukte ausbildet. Über die Akkumulation dieser stabilen PBN-$C_2H_5O\bullet$-Spin-Addukte im Laufe der Messung wird der Anteil der instabilen PBN-Spin-Addukte am Gesamtspektrum immer geringer, bis die Signalintensität fast ausschließlich von den PBN-$C_2H_5O\bullet$-Spin-Addukten hervorgerufen wird. Anhand dieses grundlegenden Befundes ließen sich einige Zusammenhänge im Bezug auf die Lag-Time-Messung eines Bieres erklären, z.B. eine in Abhängigkeit zur Ethanolkonzentration hervorgerufene höhere Signalintensität der ESR-Spektren (EtOH-Effekt). Es handelt sich bei der Lag-Time-Messung nach bisheriger Vorgehensweise um eine eher indirekte Bestimmung der Radikalgenerierung im Bier, die signifikante Verfälschungen hervorbringt.

Das Verfahren der vorliegenden Erfindung weist gegenüber bisher bekannten Verfahren verschiedene Vorteile auf.

Ersten, das eingesetzte Spin-Trap-Reagenz POBN weist eine vielfach höhere Affinität zu den sekundären Radikalen, insbesondere Hydroxyethylradikalen, auf, wodurch die Menge an Reagenz, die für eine zuverlässige Messung erforderlich ist, im Vergleich zu dem bisher verwendeten BPN deutlich geringer ist (um ein 15-Faches). Dies führt nicht nur zu einer Kostenersparnis, sondern verringert den möglichen Einfluss, den das Spin-Trap-Reagenz auf die Probe haben kann, um ein Vielfaches.

Zweitens, sowohl das Spin-Trap-Reagenz POBN als auch seine Spin-Trap-Addukte, insbesondere die POBN-Hydroxyethylradikal-Addukte, sind sehr stabil und weisen eine höhere Stabilität gegenüber der den pH-Wert verändernden Inaktivierungsreaktion auf.

Drittens, die Kombination aus der höheren Stabilität gegenüber der den pH-Wert verändernden Inaktivierungsreaktion mit der um ein 15-Faches geringeren Konzentration macht es möglich, die bei der bisherigen Methode vorliegende Beschleunigung der Radikalgenerierung über den durch PBN verursachten pH-Wert-Effekt praktisch zu umgehen.

Viertens, die Umgehung des pH-Wert-Effekts gewährleistet, dass die pH-Wert-abhängige Wirkungsweise verschiedener antioxidativ wirkender Inhaltsstoffe (phenolische Substanzen, Ascorbinsäure etc.) den in einer Bierprobe oder einer anderen Getränkeprobe vorliegenden Verhältnissen entspricht.

Fünftens, die Umgehung des pH-Wert-Effekts in Verbindung mit der hohen Auflösung der neuen Messmethode gewährleistet zusätzlich, dass es möglich wird, die Wirkungsweise bestimmter Inhaltsstoffe (siehe $SO_2$-Abhängigkeit) detailliert und logisch nachvollziehbar nachzuweisen.

Sechstens, da POBN, anders als etwa PBN, das in einer Ethanollösung gelöst werden muss, direkt in Bier und anderen alkoholhaltigen Getränken löslich ist, kann eine Beeinflussung der Messergebnisse durch zusätzliche Lösungsmittel vermieden werden. Andererseits soll eine vorausgehende Lösung von POBN in einer Wasser-Ethanol-Lösung oder einer anderen wässrigen Lösung, z.B. als Stammlösung, keinesfalls ausgeschlossen werden. Bei Getränken, die im Wesentlichen alkoholfrei sind, wie etwa Säften oder entalkoholisierte Bier, sollte eine exogene Zugabe von Ethanol im Bereich von 0,01-5 Vol.-%, vorzugsweise 3 Vol.-%, erfolgen. Auf diese Weise wird die Signalintensität der stabilisierten sekundären Radikale verstärkt und die Auswertung erleichtert.

Siebtens, aufgrund der nachgewiesenen linearen Abhängigkeit der EAP-Werte vom $SO_2$-Gehalt ist es möglich, durch entsprechende Zudotierung die Zunahme des EAP-Werts bezogen auf ein mg $SO_2$-Gehalt zu ermitteln, um so eine neue Kenngröße zu bestimmen. Diese Kenngröße macht die Auswirkungen zusätzlicher Faktoren auf die oxidative Stabilität von Bier und anderen Getränken (Metallionen, pH-Wert der Probe, andere antioxidtaiv wirkende Inhaltsstoffe etc.) in ihrer Gesamtheit zugänglich. So können beispielsweise die Charakteristika verschiedener Biersorten in ihrem antioxidativen Verhalten und die Unterschiede einzelner Biere untereinander aufgezeigt werden. Für viele Biere bei denen das EAP hauptsächlich durch den $SO_2$-Gehalt vorgegeben ist, lässt sich diese Kenngröße in einer ersten Annäherung durch den Quotienten zwischen gemessenem (ermitteltem) EAP-Wert in der Probe und dem Gesamtgehalt an $SO_2$ ermitteln.

Achtens, aufgrund der Beseitigung der Verfälschungen nach bisheriger Vorgehensweise zeichnet sich die neue EAP-Bestimmung im Vergleich zur bisherigen Methode zusätzlich durch eine sehr viel höhere Auflösung der Ergebnisse im mittleren bis hohen Bereich der oxidativen Getränkestabilität aus. Dies ermöglicht eine sehr detaillierte Beschreibung der negativen oder positiven Auswirkungen auf das EAP eines Bieres oder Getränks. Dies ist für die praktische Anwendung von entscheidender Bedeutung.

Bezogen auf die praktische Anwendung bei der Herstellung und Qualitätskontrolle von Bier kann das Verfahren der vorliegenden Erfindung dazu eingesetzt werden, die Einflüsse der einzelnen Zwischenstufen des Brauprozesses auf die oxidative Bierstabilität darzustellen. Beispielsweise können die Auswirkungen der Gärung, der Lagerung in Lagertanks, der chemisch-physikalischen Bierstabilisierung (z.B. durch Silica-Gel oder Polyvinylpolypyrrolidon, PVPP) und einzelner Filtrationsstufen und Abfüllprozesse auf das EAP überprüft und dargestellt werden.

Mit Hilfe der neuen EAP-Bestimmung können die nicht unerheblichen Kosten der Spin-Trap-Reagenzien um bis zu 80% reduziert werden. Der Einsatz der neunen EAP-Bestimmung würde gegenüber der bisherigen Methode bei routinemäßigem Einsatz 12.000-15.000 Euro pro Jahr und Betrieb einsparen (Einsparung pro Messung ca. 7 Euro; Lag- Time-Bestimmung mit 50 mM PBN/20 ml Probe im Vergleich zur EAP-Bestimmung mit 3 mM POBN/20 ml; 40 Messungen pro Woche; 50 Messungen pro Jahr).

Für die Brauereien, bei denen in Zukunft die EAP-Bestimmung routinemäßig eingesetzt wird, ergibt sich über die höhere Aussagekraft der EAP-Werte hinaus nicht nur die Möglichkeit, Abweichungen im Brauprozess rechtzeitig zu erkennen und dann gezielt einzugreifen, sondern zusätzlich eine merkliche Kostenreduzierung im Bereich der Qualitätskontrolle und - sicherung.

Ein weiterer Anwendungsbereich für die neue EAP-Bestimmung ergibt sich direkt aus dem Einfluss der Verpackungsmaterialien auf die oxidative Getränkestabilität. Aufgrund der hohen Auflösung der Ergebnisse ist die neue EAP-Bestimmung prädestiniert, die durch die Sauerstoffpermeation über die verschiedensten Verpackungsmaterialen, wie etwa Kunststoffflaschen, insbesondere aus PET oder PEN, oder Flaschen mit Sauerstoffbarriereschichten, und Verschlussvorrichtungen, wie etwa Kronenkorken, Compoundmassen mit $O_2$-ScavangerEigenschaften, verschiedene Bügelverschlusstypen (3K-, DIN-, Kugel-Kopf) oder Kunststoffverschlüsse, hervorgerufenen Einflüsse auf die oxidative Getränkestabilität mit einer hohen Genauigkeit und hinsichtlich ihrer Eignung (Qualität) zur Bewahrung der oxidativen Getränkestabilität gegenüberzustellen.

Im Gegensatz zu der bisherigen Bestimmungsmethode mittels PBN, die ungeeignet ist, das EAP eine Bieres unverfälscht aufzuzeigen, kann die hohe Aussagekraft und Auflösung der EAP-Bestimmung in Zukunft zur realistischen Beschreibung der oxidativen Stabilität von Bier und anderen Getränken herangezogen werden.

## Genaue Beschreibung der Erfindung

Die vorliegende Erfindung soll anhand der folgenden Beispiele und im Zusammenhang mit beigefügten Figuren näher erläutert werden.

**Figur 1**  zeigt die Ergebnisse der Messungen zur Stabilität der mittels PBN "getrappten" Hydroxyl- bzw. Hydroxyethylradikale (PBN-Spin-Addukte).

*Figur 1A*  zeigt die Stabilität der PBN-Spin-Addukte ("getrappte" Hydroxyl- bzw. Hydroxyethylradikale) in einem 0,1 M Phosphat-Puffer (pH-Wert = 4) nach Generierung über ein Fenton-PBN-System [FeSO$_4$ · 7 H$_2$O 0,002 g/5 ml; PBN (25 mM) 0,0245 g/5 ml; H$_2$O$_2$ (30 %) 0,025 ml/5 ml - Spezialapparatur mit Mischzelle] ohne (a) und mit EtOH 3,0 Vol.-% (b) über die Zeit.

Figur 1B     zeigt den Anstieg der Signalintensität der PBN-Spin-Addukte (Wasser-EtOH-Lösung) mit der EtOH-Konzentration nach Röntgenbestrahlung zur Radikalgenerierung.

Figur 1C     zeigt die ESR-Spektren der PBN-Spin-Addukte 5 min nach der Röntgenbestrahlung zur Radikalgenerierung mit 5,0 Vol.-% EtOH und ohne EtOHZugabe.

**Figur 2**     zeigt die pH-Wert-abhängige Hydroxylradikalgenerierung bei der Fenton-Reaktion.

**Figur 3**     zeigt die Abhängigkeit der Lag-Time-Bestimmung mittels PBN vom pH-Ausgangswert der Bierrpbe im Forciertest bei 60 °C (3a. pH-Wert = 4,32, Lag-Time = 46,7 min; 3b. pH-Wert = 4,03, Lag-Time = 53,2 min).

**Figur 4**     zeigt den konzentrationsabhängigen Einfluss des Spin-Trap-Reagenzes PBN auf den pH-Wert-Verlauf im Rahmen einer Lag-Time-Messung (pH-Wert-Effekt auf die Radikalgenerierung) (4a. 50 mM PBN; 4b. 30 mM PBN; 4c. 0 mM PBN).

**Figur 5**     zeigt die divergierenden Kurvenverläufe und Lag-Time-Werte zwischen unterschiedlichen PBN-Konzentration (30 mM und. 70 mM PBN) in Abhängigkeit vom vorliegenden EAP einer Bierprobe für den Bereich einer kleinen bis mittleren oxidativen Bierstabilität (5a. 70 bzw. 30 mM PBN im kleinen Bereich; 5b. im kleinen bis mittleren Bereich; 5c. im mittleren Bereich der oxidativen Bierstabilität).

**Figur 6**     zeigt den durch die PBN-Konzentration verursachten Lag-Time-Verlust im Bereich der mittleren bis hohen oxidativen Bierstabilität für den PBN-Konzentrationsbereich von 5, 10 und 50 mM (Forciertest 63°C; 6a. 50 mM PBN → Lag-Time ~ 82 min; 6b. 10 mM PBN → Lag-Time ~ 137 min; 6c. 5 mM PBN → Lag-Time ~ 201 min).

**Figur 7**     zeigt die Ergebnissse der Messungen zur Stabilität der mittels PBN und POBN "getrappten" Hydroxyl- und Hydroxethylradikale (Spin-Trap-Addukte) in einem 0,1 M Phosphat-Puffer (pH-Wert = 4) nach Generierung über ein Fenton-PBN- bzw. Fenton-POBN-System [FeSO$_4$ · 7 H$_2$O 0,002 g/5 ml; PBN (25 mM) 0,0245 g/5 ml; H$_2$O$_2$ (30 %) 0,025 ml/5 ml - Spezialapparatur mit Mischzelle] ohne (a, b) und mit EtOH 3 Vol.-% (c, d) über die Zeit im Direktvergleich.

**Figur 8**     zeigt den im Rahmen einer Messung zur Bestimmung des EAPs einer Bierprobe auftretenden, konzentrationsabhängigen Einfluss der Spin-Trap-Reagenzien PBN und POBN auf den pH-Wert-Verlauf (pH-Wert-Effekt auf die Radikalgenerierung) (8a. 50 mM PBN; 8b. 30 mM PBN; 8c. 30 mM POBN; 8d. 10 mM POBN; 8e. 5 mM POBN; 8f. ohne Spin-Trap-Zugabe).

**Figur 9**     zeigt die Ergebnisse der EAP-Bestimmung mittels POBN im Direktvergleich zur bisher üblichen Lag-Time-Messung (PBN) für den Bereich der mittleren (Figur 9a) und den Bereich der mittleren bis hohen oxidativen Bierstabilität (Figur 9b).

Figur 9A     Probe: "Warsteiner"-Pils
(A): Lag-Time-Messung mit 30 mM PBN; Forciertest 63 °C; Lag-Time = 83 min; (B): EAP-Bestimmung mit 3 mM POBN; Forciertest 63 °C; Lag-Time = 200 min.

Figur 9B     Probe: "Licher"-Pils
(A): Lag-Time-Messung mit 30 mM PBN; Forciertest 63 °C, Lag-Time = 102 min; (B): EAP-Bestimmung bei 3 mM POBN; Forciertest 63 °C; EAP-Wert = 336 min.

**Figur 10**     zeigt die Abhängigkeit der Lag-Time (Figur 10A, B) und die des EAP-Werts (Figur 10D) vom SO$_2$-Gehalt einer Bierprobe sowie die Entwicklung der Kurvenverläufe im Verlauf der EAP-Bestimmung über die Zeit des Forciertests (63 °C) bei verschiedenen SO$_2$-Gehalten (Figur 10C).

Figur 10A     1. Lag-Time = 15,0 min → SO$_2$-Gehalt = 3,5 mg/l;
2. Lag-Time = 31,2 min → SO$_2$-Gehalt = 4,5 mg/l;

3. Lag-Time = 43,8 min → SO$_2$-Gehalt = 5,5 mg/l;
4. Lag-Time = 54,1 min → SO$_2$-Gehalt = 6,5 mg/l;
5. Lag-Time = 62,5 min → SO$_2$-Gehalt = 7,5 mg/l;
6. Lag-Time = 70,3 min → SO$_2$-Gehalt = 8,5 mg/l;
7. Lag-Time = 76.0 min → S02-Gehalt = 9,5 mg/l;
8. Lag-Time = 85,3 min → SO$_2$-Gehalt = 11,5 mg/l;
9. Lag-Time = 91,4 min → SO$_2$-Gehalt = 13,5 mg/l;

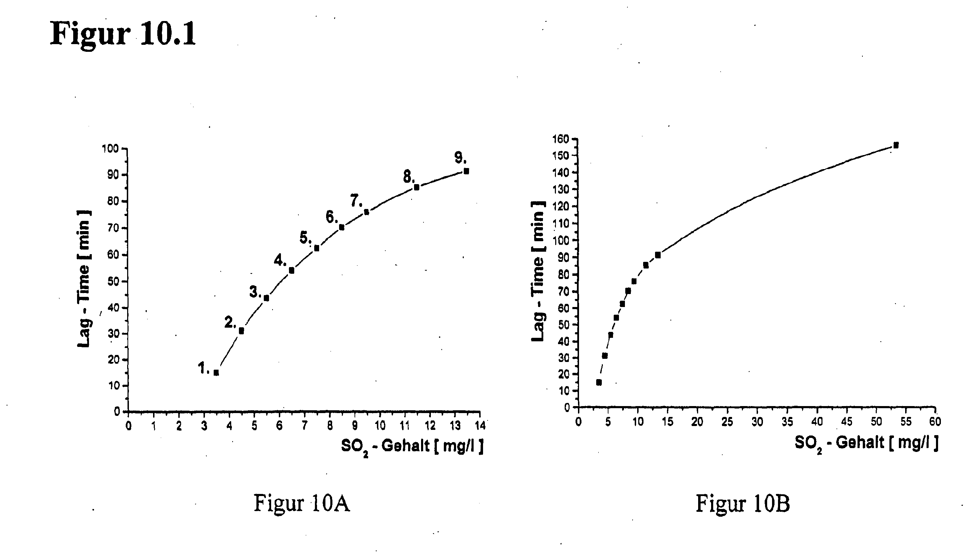

*Figur 10B*    Angaben wie in *Figur 10A,* zusätzlich:
10. Lag-Time = 156 min → SO$_2$-Gehalt = 53,3 mg/l;

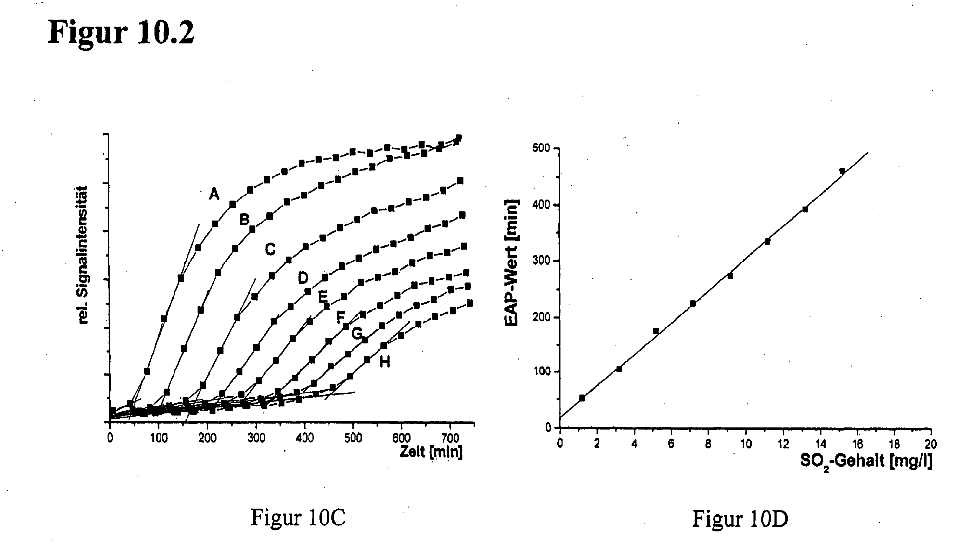

*Figur 10C*    zeigt die Entwicklung der Kurvenverläufe im Verlauf der EAP-Bestimmung mit steigendem SO$_2$-Gehalt in einer Bierprobe.

*Figur 10D*    A: EAP-Wert = 52 min → SO$_2$-Gehalt = 1,2 mg/l;
B: EAP-Wert = 105 min → SO$_2$-Gehalt = 3,2 mg/l;
C: EAP-Wert = 176 min → SO$_2$-Gehalt = 5,2 mg/l;
D: EAP-Wert = 225 min → SO$_2$-Gehalt = 7,2 mg/l;
E: EAP-Wert = 275 min → SO$_2$-Gehalt = 9,2 mg/l;
F: EAP-Wert = 335 min → SO$_2$-Gehalt = 11,2 mg/l;
G: EAP-Wert = 393 min → SO$_2$-Gehalt = 13,2 mg/l;
H: EAP-Wert = 461 min → SO$_2$-Gehalt = 15,2 mg/l.

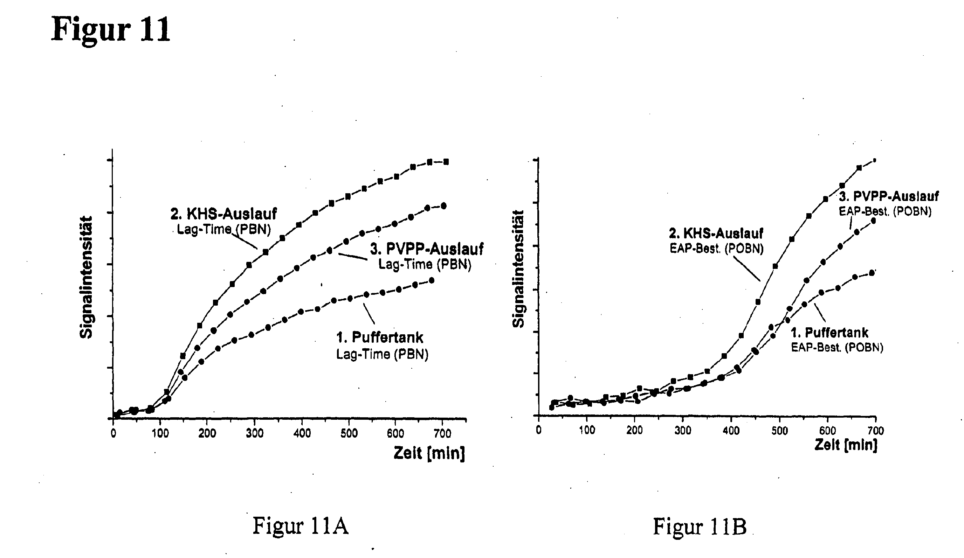

**Figur 11**    zeigt am Besiel der chemisch-physikalischen Bierstabilisierung die Eignung der EAP-Bestimmung, die Einflüsse einzelner Brauprozessstufen auf das EAP einer Probe nachzuweisen.

*Figur 11A*    Lag-Time-Messungen mittels 50 mM PBN (Forciertest 63 ° C).

1. Puffertank - (Lag-Time - PBN)
2. KHS-Auslauf = nach chemisch-physikalischer Bierstabilisierung Eiweißstabilisierung (Silica-Gel) - (Lag-Time - PBN)
3. PVPP-Auslauf = nach chemisch-physikalischer Bierstabilisierung mittels Polyvinyl-poly-pyrrolidon - (Lag-Time - PBN)

*Figur 11B*    EAP-Bestimmung mittels 3 mM POBN (Forciertest 63 °C)

1. Puffertank - (EAP-Bestimmung - POBN)
2. KHS-Auslauf = nach chemisch-physikalischer Bierstabilisierung (Eiweißstabilisierung mit Silica-Gel) - (EAP-Bestimmung - POBN)
3. PVPP-Auslauf = nach chemisch-physikalischer Bierstabilisierung mittels Polyvinyl-poly-pyrrolidon - (Lag-Time - POBN)

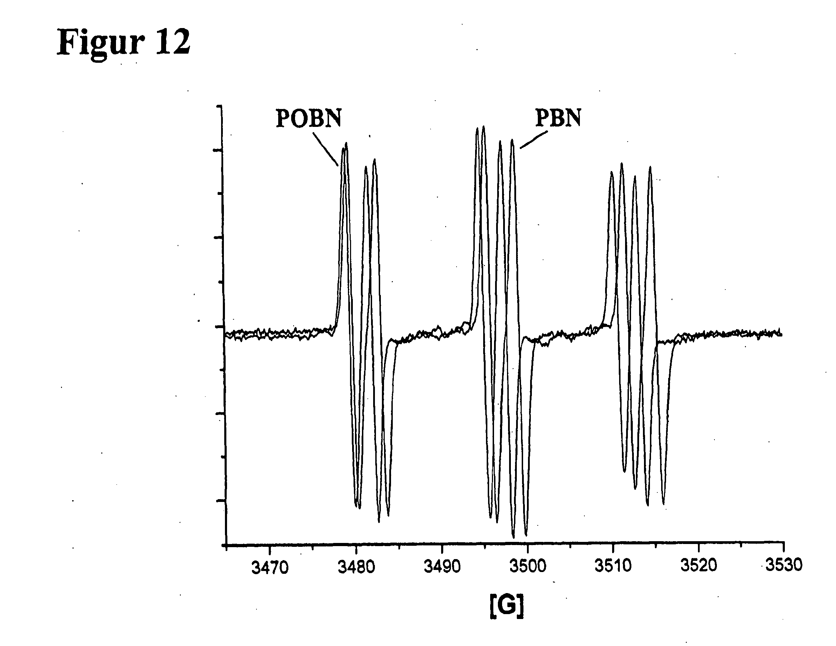

**Figur 12**    zeigt die ESR-Spektren von N-*tert*-Butyl-$\alpha$-phenylnitron (PBN) und N-Butyl-*tert*-$\alpha$-(-pyridyl)nitron-N-oxid (POBN).

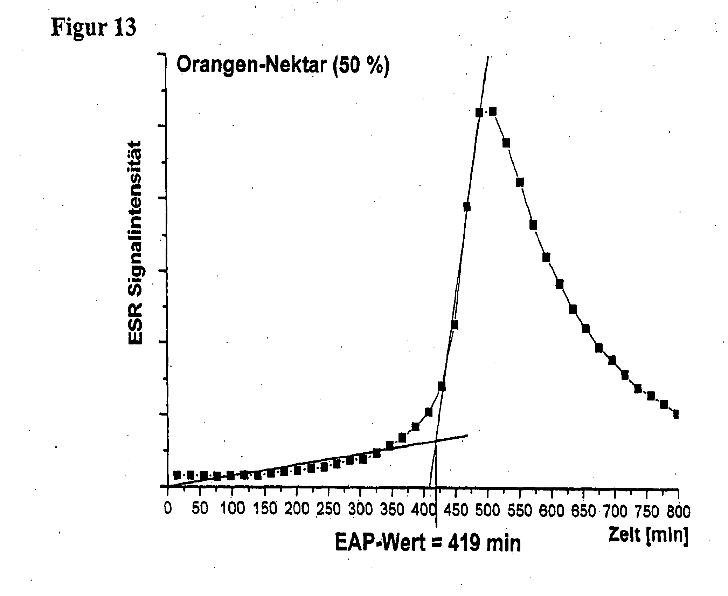

**Figur 13**    zeigt die Anwendung der EAP-Bestimmung im Saftbereich am Beispiel:
Orangen-Nektar (50%), ALDI, Charge: M35 02:05 06.07, MHD 30.06.06 Ascorbinsäuregehalt - Herstellerangaben: keine Angaben
Eigenanalyse: Analyse von Ascorbinsäure in Säften, Methode: HPLC, UV-Detektion, MEBAK Band II, 4. Auflage, 2002, 3.7.1.1.
Ascorbinsäuregehalt: 122 mg/l
EAP-Wert: 419 min (Forciertest 60 °C)

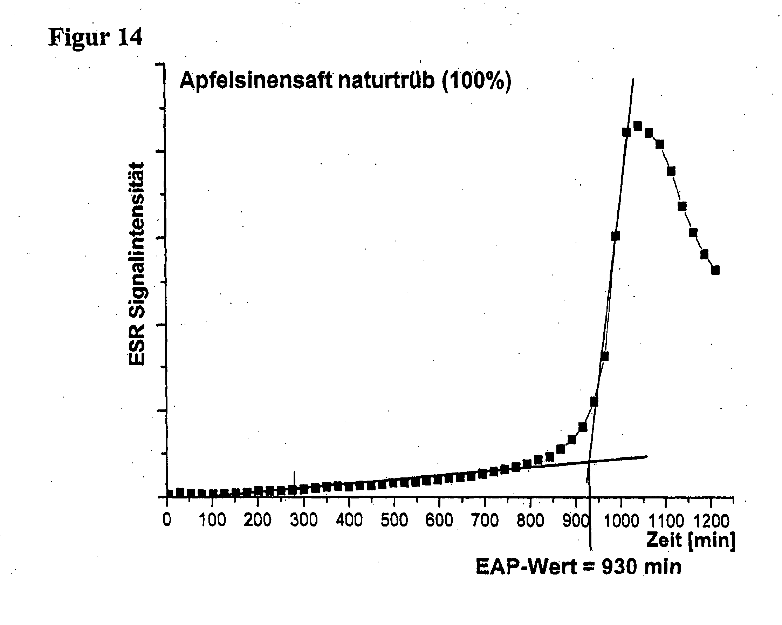

**Figur 14**    zeigt die Anwendung der EAP-Bestimmung im Saftbereich am Besipiel:
Apfelsinensaft naturtrüb (100%), Frucht-Oase, ALDI, MHD 30.06.06
Ascorbinsäuregehalt - Herstellerangaben: 320 mg/l
Eigenanalyse: (Referenz siehe oben)
Ascorbinsäuregehalt: 351 mg/l

EAP-Wert: 930 min (Forciertest 60 °C)

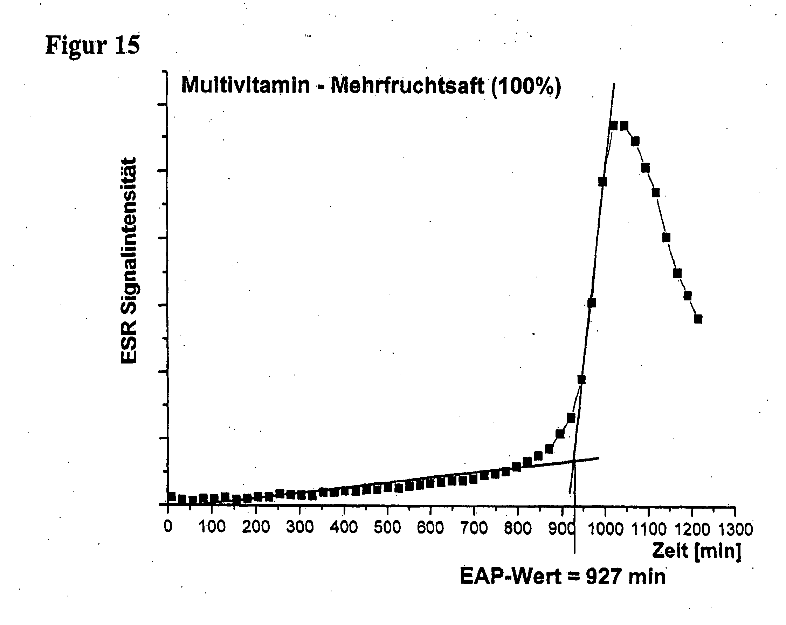

**Figur 15**     zeigt die Anwendung der EAP-Bestimmung im Saftbereich am Besipiel:
Multivitamin-Mehrfruchtsaft (100%), Frucht-Oase, ALDI, MHD 30.06.06
Ascorbinsäuregehalt - Herstellerangaben: 300 mg/l
Eigenanalyse: (Referenz siehe oben)
Ascorbinsäuregehalt: 327 mg/l
EAP-Wert: 927 min (Forciertest 60 °C)

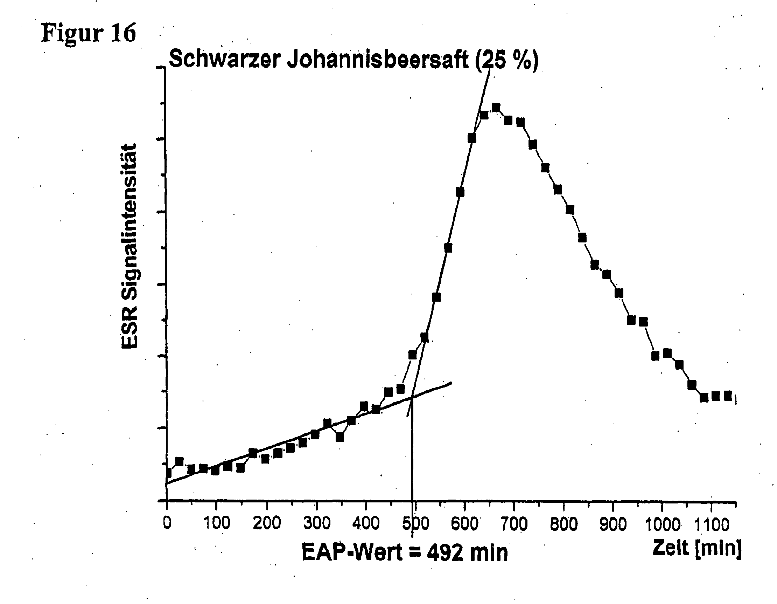

**Figur 16**     zeigt die Anwendung der EAP-Bestimmung im Saftbereich am Besipiel:
Schwarzer Johannisbeersaft (25%), Elmenhorster, ALDI, MHD 01.06.06
Ascorbinsäuregehalt - Herstellerangaben: 250 mg/l
Eigenanalyse: (Referenz siehe oben)
Ascorbinsäuregehalt: 159 mg/l
EAP-Wert: 492 min (Forciertest 60 °C)

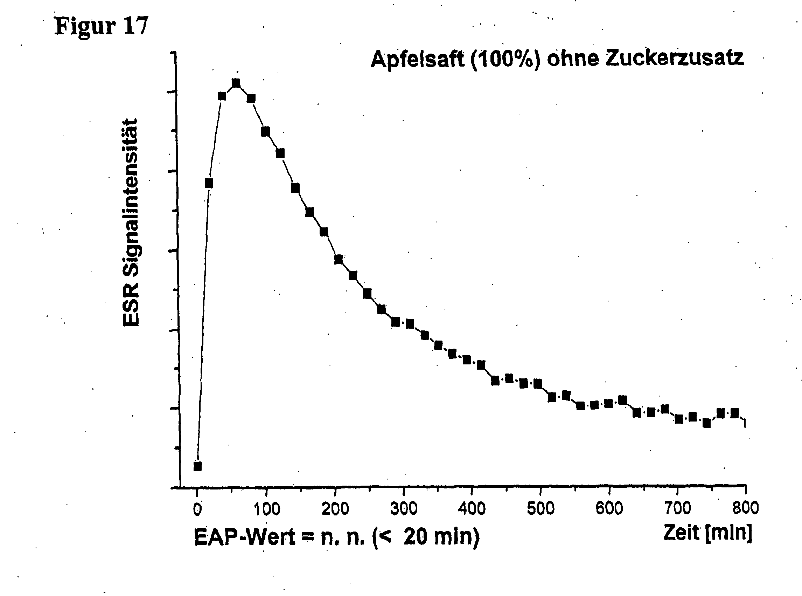

**Figur 17**     zeigt die Anwendung der EAP-Bestimmung im Saftbereich am Besipiel:
Apfelsaft (100%) ohne Zuckerzusatz, RIO DORO, ALDI, Charge: b15Q126G22, MHD 01.06.06
Ascorbinsäuregehalt - Herstellerangaben: keine Angaben
Eigenanalyse: (Referenz siehe oben)
Ascorbinsäuregehalt: 1,7 mg/l
EAP-Wert: n.n. (< 20 min) (Forciertest 60 °C)

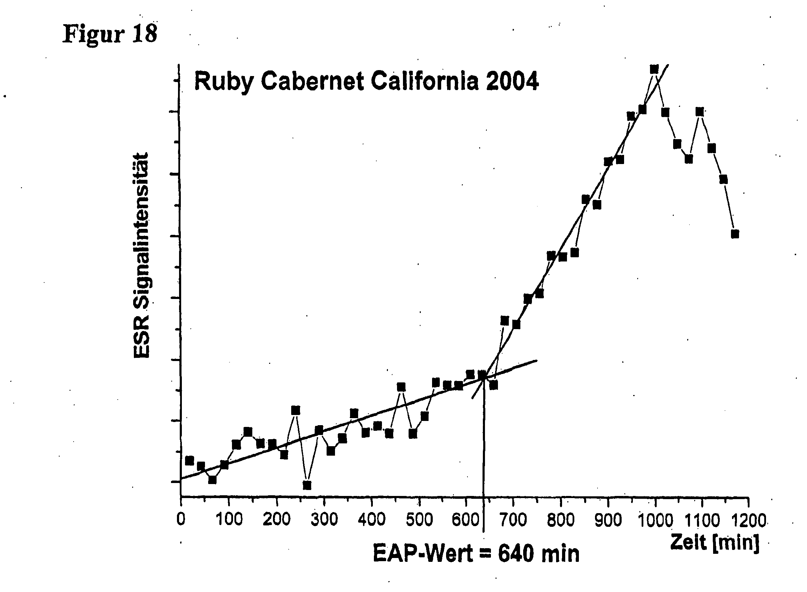

**Figur 18**     zeigt die Anwendung der EAP-Bestimmung im Weinbereich am Beispiel: Ruby Cabernet California 2004,
13,5 Vol.-%, ALDI, Charge: 115.0741 EAP-Wert: 640 min (Forciertest 60 °C).

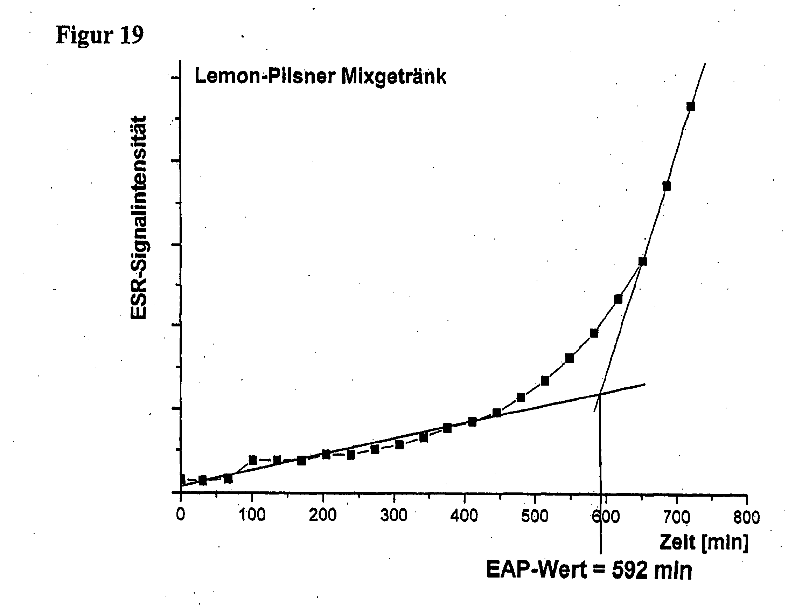

**Figur 19**     zeigt die Anwendung der EAP-Bestimmung im Bereich der Biermixgetränke am Beispiel:
Lemon-Pilsner-Mixgetränk, Licher Fresh Lemon 2,5 Vol.-%
EAP-Wert: 592 min (Forciertest 63 °C)

**BEISPIELE**

Beispiel 1: *Messverfahren*

*1.1. Technische Ausstattung*

Zur Lag-Time-Messung mit PBN und für die EAP-Bestimmung mittels POBN wurden folgende ESR-Spektrometer eingesetzt:

Type: X-Band-Spektrometer; Bruker (ESP-300); Cavity-Type: Bruker 4108 TMH Nr.: 8603.
Type: X-Band-Spektrometer; Magnettech Miniscope MS 100.

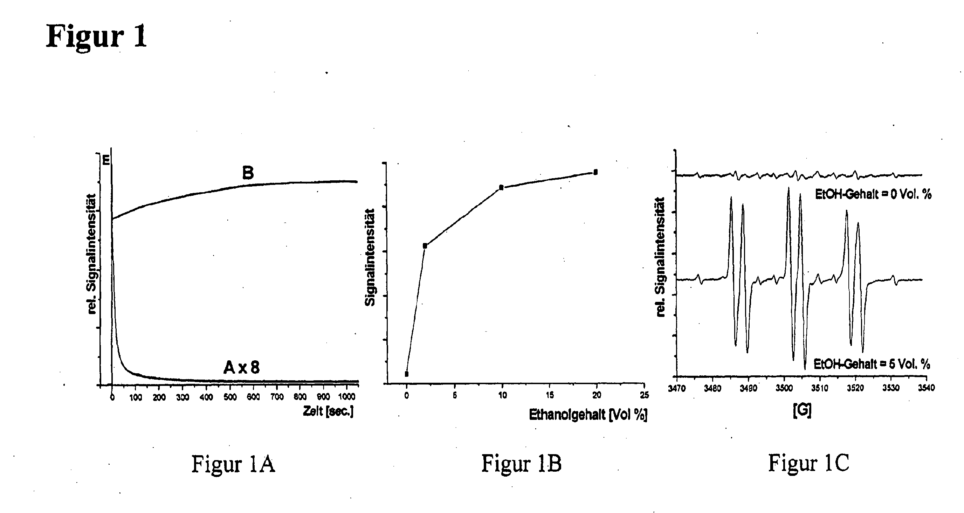

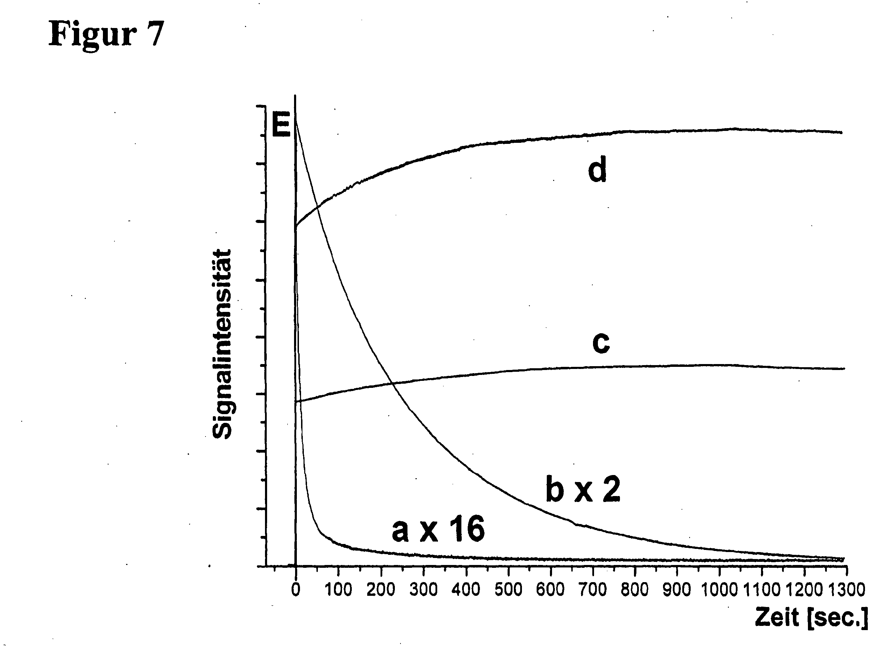

Die Bestrahlungsversuche zur künstlichen Radikalgenerierung (Bestrahlungsversuche Figur 1B, C) erfolgte mittels Röntgenbestrahlung (Röntgenröhre von Seifert Debyflex).
Der Begriff "Röntgen-System" zur Radikalgenerierung, wie hier verwendet, beschreibt die künstliche Radikalgenerierung über ionisierende Strahlung (Röntgenstrahlung), wie sie im Stand der Technik bekannt ist.
Die Messungen zur Stabilität der Spin-Trap-Addukte (PBN- bzw. POBN-Spin-Addukte, d.h. "getrappte" Hydroxyl- und Hydroxyethylradikale) unter künstlicher Radikalgenerierung mit Hilfe eines Fenton-Systems (Figur 1A, *Figur 7*) erfolgten mit einer im eigenen Haus entwickelten und gebauten Spezialapparatur. Mit diesem speziellen Aufbau ist es unter Verwendung einer Mischzelle möglich, ein Fenton-System, d.h. Zusammenführung von Wasserstoffperoxid und Metallionen ($Fe^{2+}$), in unterschiedlichen Lösungen, direkt in der Messküvette zu erzeugen und die Stabilisierungsreaktion mit Spin-Trap-Reagenzien bzw. den Zerfall der Addukte über die Time-Sweep-Funktion des ESR-Spektrometers (Bruker ESP-300, siehe oben) unmittelbar zu verfolgen (Figur 1A, *Figur 7*).
Der Begriff "Fenton-System", wie hier verwendet, bezeichnet ein Reaktionssystem, in dem die Fenton-Reaktion unter experimentellen Bedingungen durch die Zusammenführung von Wasserstoffperoxid und Metallionen ($Fe^{2+}$) in unterschiedlichen Lösungen gezielt gestartet wird. Das Fenton-System dient hauptsächlich zur künstlichen Radikalgenerierung, insbesondere von Hydroxlradikalen.

*1.2. Reagenzien*

N-*tert*-Butyl-$\alpha$-phenylnitron (PBN) 98 %, $C_{11}H_{15}NO$, M = 177,2 g/mol;
(SIGMA CHEMICAL CO., P.O. Box 14508 St. Louis, MO 63178 USA, Tel. 314-771-5750; SIGMA-ALDRICH CHEMIE GmbH P.O. 1120, 89552 Steinheim, Germany, Tel. 49-7329-970; Nr. B-7263, 5g, Lot 31K1498, mind. 98 % [3376-24-7], EC No 222-168-6. "For RAD use only. Not for drug, household or other uses." W5/R).

N-*tert*-Butyl-$\alpha$-(4-pyridyl)nitrone N-oxide (POBN) 99%, $C_{10}H_{14}N_2O_2$, M = 194,23 g/mol;
(SIGMA-ALDRICH CHEMIE GmbH P.O. 1120, 89552 Steinheim, Germany, Tel. 49-7329-970, 1g, mind. 99 %, Nr. 215430, Lot 01609KA, CAS-Nr. 66893-81-0, Beil 145376, EG/EC No 266-512-3. "For RAD use only. Not for drug, household or other uses." W5/R).

Ethanol *pro analysis* 99,8 %, $C_2H_5OH$, M = 46,07 g/mol, Dichte: 11 = 0,79 kg;
(Merck KgaA, 64271 Darmstadt, Germany, Tel. 49(0)6151 72-2440; EG-Nr.: CE 200-578-6, Charge/Lot K29301283125, Nr. 1.00983.1011, UN 1170, Reinheit mind. 99,8 %, VbF B3.2 (IMDG-Code), mind. verw. bis 31.05.06, R: 11, S: 7-16).

Eisen (II)-sulfat-Heptahydrat 99,5 %, $FeSO_4{}^*7H_2O$, M = 278,02 g/mol;
(MERCK KGaA, 64271 Darmstadt, Germany, Tel. 49(0)6151 72-2440, 1 kg, mind. 99,5 %, Nr. 1.03965.1000, Charge/Lot: TA700665 951, EG/EC No CE231-753-5, R: 22 S: 24/25).

Wasserstoffperoxid 30 % (w/w)) $H_2O_2$, M = 34,01 g/mol;
(MERCK Schuchardt OHG, 85662 Hohenbrunn, Germany, Tel. 49(0)8102 802-0, 11, Nr. 8.22287.1000, Charge/Lot: K33213287 420, EG/EC No 2317650 R: 34 S: 3-26-36/37/39-45).

Natriumsulfit wasserfrei zur Analyse; $Na_2SO_3$; M = 126,04 g/mol; Dichte: 2,63 g/cm3 (20°C) MERCK-Art-Nr: 106657; CAS-Nummer: 7757-83-7; Giftklasse CH: 3 - starke Gifte; HS-Warennummer: 28321000; EG-Nr.: 231-821-4; Lagerklasse (VCl): LGK 10-13; Lagerung: ohne Einschränkung; WGK: 1-schwach wassergefährdend; Entsorgung: 28.

*1.3. Verwendete ESR-Parametereinstellungen*

Messungen der in *Figur 1A* dargestellten Ergebnisse:
Type: X-Band-Spektrometer; Bruker (ESP-300), Sweep Time Funktion (2 Peak): Center Field: 3500 [G]; Attenuation: 10 dB; Phase: 0 [deg]; Conversion Time: 320,00 ms; Time Constant: 163.84 ms; Data Points: 4096; Number of Scan: 1; Sweep Time: 1310.7 ms; Receiver Gain: (a) = $4 \cdot 10^4$ / (b) = $2,5 \cdot 10^3$; Mod. Ampl.: 0,1 [mT]; Mod. Frequenz: 100 kHz; Cavity-Type: Bruker 4108 TMH Nr.: 8603;

Messungen der in den *Figur 1B,* C dargestellten Ergebnisse:
Type: X-Band-Spektrometer; Bruker (ESP-300), Center Field: 3504 [G]; Attenuation: 10 dB; Conversion Time: 40,96 ms.; Phase: 2 [deg]; Time Constant: 40.96 ms; Receiver Gain: $1 \cdot 10^5$; Sweep Width: 7.0 [mT]; Data Points: 1024; Number of Scan: 10; Mod. Ampl.: 0,1 [mT]; Mod. Frequenz: 100 kHz; Cavity-Type: Bruker 4108 TMH Nr.: 8603

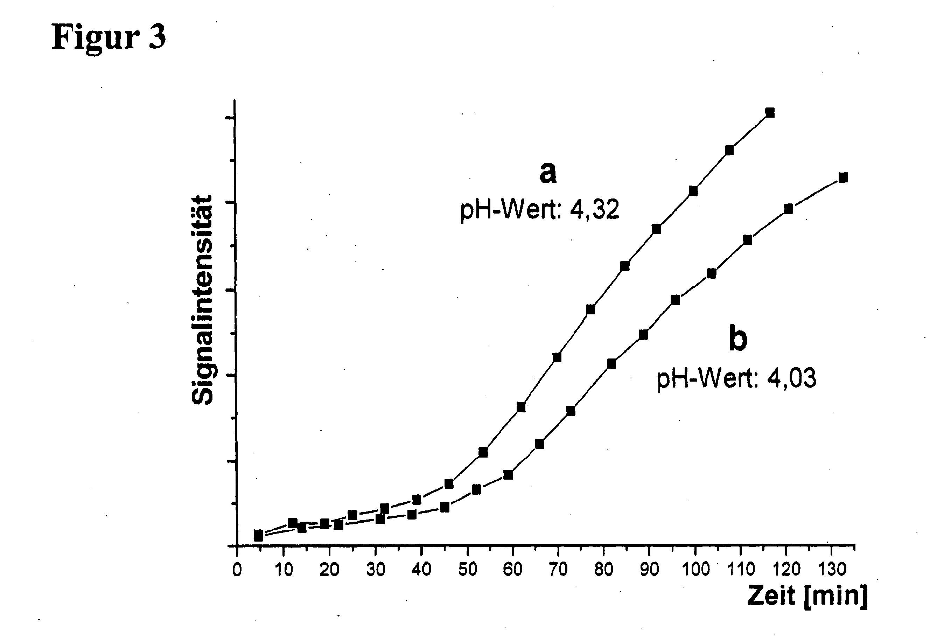

Messungen der in den *Figuren 3, 5, 10A, B* dargestellten Ergebnisse:
Type: X-Band-Spektrometer; Bruker (ESP-300); Center Field: 3500 [G]; Attenuation: 10 dB; Conversion Time: 40,96 ms.; Phase: 0-5 [grd]; Time constant: 40.96 ms; Receiver Gain: $1 \cdot 10^5$; Number of Scan: 3; Sweep Width: 7.0 mT; Mod. Ampl.: 0,1 [mT]; Mod. Frequenz: 100 kHz; Data points: 1024; Number of Scan: 3; Cavity-Type: Bruker 4108 TMH Nr.: 8603

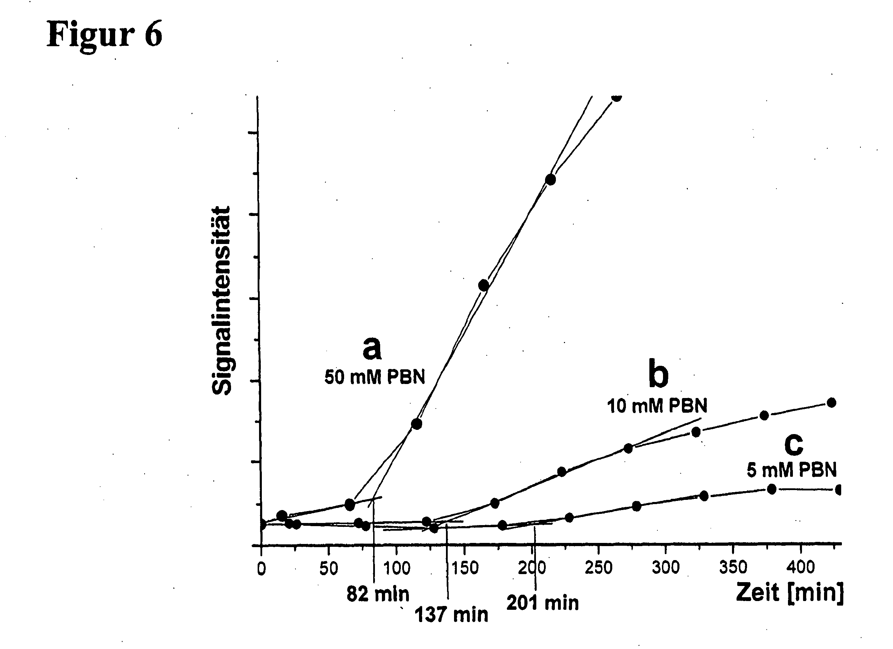

Messungen der in den *Figuren 6, 9A, B, 10C, D, 11A, B* dargestellten Ergebnisse:
Type: X-Band-Spektrometer; Magnettech Miniscope MS 100; Center Field: 3352 [G]; Attenuation: 3 dB; Sweep Time: 40 sec.; Sweep Width: 24 [G]; Receiver Gain: 300; Phase: 180 [grd]; Mod. Ampl.: 1 [G]; Number of Scan: 3; Mod. Frequenz: 100 kHz; Data points : 1024;

Messungen der in *Figur* 7 dargestellten Ergebnisse:

Type: X-Band-Spektrometer; Bruker (ESP-300); Sweep Time Funktion (2 Peak): Center Field: 3500 [G]; Attenuation: 10 dB; Phase: 0 [deg]; Conversion Time: 320,00 ms; Time constant: 163.84 ms; Data points: 4096; Number of Scan: 1; Sweep Time: 1310.7 ms; Receiver Gain: (a) = 4·104 / (b) = 5-103 / (c) = 2,5·103 / (d) = 2,5·103; Mod. Ampl.: 0,1 [mT]; Mod. Frequenz: 100 kHz; Cavity-Type: Bruker 4108 TMH Nr.: 8603;

*1.4. Durchführung der Messung*

*1.4.1. Allgemeine Vorgehensweise am Beispiel von Bier*

Einzelprobe: 12 ml Bier + optional EtOH (z.B. 0,1 ml) + 0,15 ml POBN-Lösung → Probevolumen = 12,25 ml (ingesamt 14 Proben).

Bei Bier, das üblicherweise einen Alkoholgehalt von ca. 5,0 Vol.-% aufweist, kann die Messung auch ohne EtOH-Zugabe durchgeführt werden. Das Spin-Trap-Reagenz POBN ist im Bier löslich und kann auch direkt zugegeben werden. Das Beispiel beschreibt lediglich eine praxisorientierte Durchführung, bei der das Einwiegen für jede Einzelprobe entfällt.

Ansatz der POBN-Lösung für eine 3 mM POBN-Konzentration im Gesamtprobenvolumen:

POBN 194,23 g/mol (99 %): 194,23 g/mol/99 % · 100 % = 196,2 g/mol
196,2 mg/mmol/1000 ml··12,25 ml/Probe · 3 mM = 7,21 mg/Probe
Insgesamt 14 Proben → 14 · 7,21 mg/Probe = 100,94 mg;
100,94 mg (POBN 99 %) in 2,1 ml (14 · 0,15 ml) destilliertem $H_2O$ gelöst;

Verfahrensschritte:

(a) Bereitstellen der Probe;
(b) Hinzufügen von 0,1 ml EtOH + 0,15 ml POBN-Lösung;
(c) Durchführen der Analyse mittels ESR-Spektroskopie (Forciertest 63°C); (ESR-Parametereinstellung - X-Band-Spektrometer Bruker (e-scan): Center Field: 3467 [G]; Attenuation: 3 dB; Phase: 328.47 [deg]; Conversion Time: 20.480 ms; Data points: 512; Time constant: 81.92 ms; Number of Scan: 10; Sweep Time: 10.486 s; Receiver Gain: 3.17e+003; Mod. Ampl.: 1,18 [G]; Mod. Frequenz: 86.00 kHz; Frequency: 9.776 GHz);
(c1) Probenahme (Messprobe) aus dem Forciertest in einem gewählten Zeitintervall bzw. zu einer bestimmten Zeit;
(c2) Aufnahme der ESR-Spektren von jeder einzelnen Messprobe;
(d) Auswertung des EAP-Werts über die ESR-Einzelspektren aller einzelnen Messproben;
(e) Darstellung der Ergebnisse über entsprechende Software (z.B. ORIGIN).

Die Vorgehensweise bei der Messung von Mischungen von Bier mit anderen Getränken (Biermixgetränken) entspricht weitestgehend derjenigen, wie für Bier beschrieben. Bei einem zu geringen Alkoholgehalt, z.B. bei Mischungen von Bier mit alkholfreien Getränken, wird, je nach Mischungsverhältnis, die Zugabe von 0,01-3,0 Vol.-% EtOH empfohlen. Auch bei entalkoholisierten ("alkoholfreien") Bieren empfiehlt sich eine entsprechende Zugabe von EtOH.

*1.4.2 Saft*

Die Vorgehensweise bei der Messung von Saft entspricht weitestgehend derjenigen, wie oben für Bier beschrieben (Forciertest bei 60°C bevorzugt).

Für Säfte ist eine EtOH-Zugabe von 0,01-5,0 Vol.- % (vorzugsweise 3,0 Vol.-%) zu empfehlen. Dadurch wird eine höhere Signalintensität bei den "getrappten" sekundären Radikalen erreicht und die Auswertung erleichtert. Bei naturtrüben Säften mit sehr hohem Fruchtanteil ist eine Zentrifugation der Saftproben erforderlich (5000 U/min, 5 min) (Forciertest bei 60 °C bevorzugt).

Der im Vergleich zu Bier unterschiedliche Kurvenverlauf (Abnahme nach Maximum) ist bei den Säften auf den niedrigeren pH-Wert (z.B. pH 3,2-3,6) zurückzuführen, wodurch die Stabilität der Spin-Trap-Addukte herabgesetzt wird. Für Säfte mit einem hohen pH-Wert (z.B. Karottensaft) sind die Kurvenverläufe, in Analogie zum Bier, durch einen weiteren Anstieg gekennzeichnet.

*1.4.3. Wein*

Die Vorgehensweise bei der Messung von Wein entspricht weitestgehend derjenigen, wie oben für Bier beschrieben. Da Wein einen höheren Alkoholgehalt hat, ist die zusätzliche Zugabe von EtOH nicht notwendig. Aufgrund des niedrigen pH-Werts ist aber eine etwas höhere Spin-Trap-Konzentration (5 mM POBN) zu empfehlen.

Beispiel 2: *Nachweis der Stabilität der Hydroxyethylradikal-Addukte*

Mit Hilfe eines speziellen radikalgenerierenden Aufbaus (Fenton-System) und durch Bestrahlungsversuche (Röntgenstrahlung zur Radikalerzeugung) konnte gezeigt werden, dass bei der Lag-Time-Messung nur im geringfügigen Maße Hydroxylradikale direkt nachgewiesen werden. Vielmehr wird die Signalintensität der ESR-Spektren hauptsächlich durch das sekundäre Hydroxyethylradikal verursacht, das offensichtlich wesentlich stabilere PBN-Spin-Addukte ausbildet *(Figur 1)*. Der Verlauf in Kurve (a) in *Figur 1A* zeigt, dass die nach der Generierung über ein Fenton-System (starker Anstieg während der Injektion bis E) gebildeten, stabilisierten Hydroxyl-Addukte (PBN) innerhalb einer Minute fast vollständig zerfallen sind, während die in einem Fenton-System unter EtOH-Zugabe entstehenden Hydroxyethyl-Addukte (PBN) auch nach 17 min praktisch unverändert vorliegen (Kurve (b)). Der zusätzliche Anstieg der Kurve (b), d.h. die Zunahme der Signalintensität, ist auf die Bildung weiterer Radikale (Fenton-Reaktion), deren Reaktion mit dem EtOH und die hohe Stabilität der daraus resultierenden PBN-Spin-Addukte zurückzuführen. Die weitere Radikalbildung lässt sich auch im Kurvenauslauf den Fenton-PBN-Systems ohne EtOH-Zugabe (Kurve (a)) beobachten. Über die Akkumulation der stabilen PBN-$C_2H_5O\bullet$-Spin-Addukte im Laufe der Lag-Time-Messung wird der Anteil der instabilen PBN-Spin-Addukte (z.B. Hydroxyl-Addukte) am Gesamtspektrum immer geringer, bis die Signalintensität fast ausschließlich von den PBN-$C_2H_5O\bullet$-Spin-Addukten hervorgerufen wird.

*Figur 1B* zeigt den Anstieg der Signalintensität der PBN-Spin-Addukte (wässrige Lösung) mit der EtOH-Konzentration nach Röntgenbestrahlung zur Radikalgenerierung bei gleicher Bestrahlungsdauer und Intensität.

In *Figur 1C* werden die ESR-Spektren 5 min nach Bestrahlung der wässrigen PBN-Lösung mit und ohne EtOH verglichen. Die typischen Triplett-von-Dublett-Signale stammen von Hydroxyethyl-Addukten (unten, unter 5 Vol.-% EtOH-Zugabe), während die durch die Bestrahlung entstandenen Hydroxyl-Addukte (oben, ohne EtOH-Zugabe) bereits ausreagiert sind.

Anhand dieses grundlegenden Befundes ließen sich einige Zusammenhänge im Bezug auf die Lag-Time-Messung eines Bieres erklären, z.B. eine in Abhängigkeit zur Ethanolkonzentration hervorgerufene höhere Signalintensität der ESR-Spektren (EtOH-Effekt) [18].

Beispiel 3: *Abhängigkeit des Lag-Time-Werts vom pH-Ausgangswert*

Ein weiterer Gesichtspunkt der Arbeiten war es, die Abhängigkeit des gemessenen Lag-Time-Werts von den verschiedenen Parametern des Forciertests zu ermitteln. Dies ist insbesondere dann von Bedeutung, wenn ein experimentell bestimmter Lag-Time-Wert mit dem EAP oder der weit weniger scharf zu erfassenden Geschmacksstabilität eines Bieres reproduzierbar korreliert werden soll. Hierbei ist es wichtig, zwischen den Effekten, die in der Messmethode begründet liegen, und den "echten" Effekten, die durch die Bierinhaltsstoffe hervorgerufen werden, zu unterscheiden.

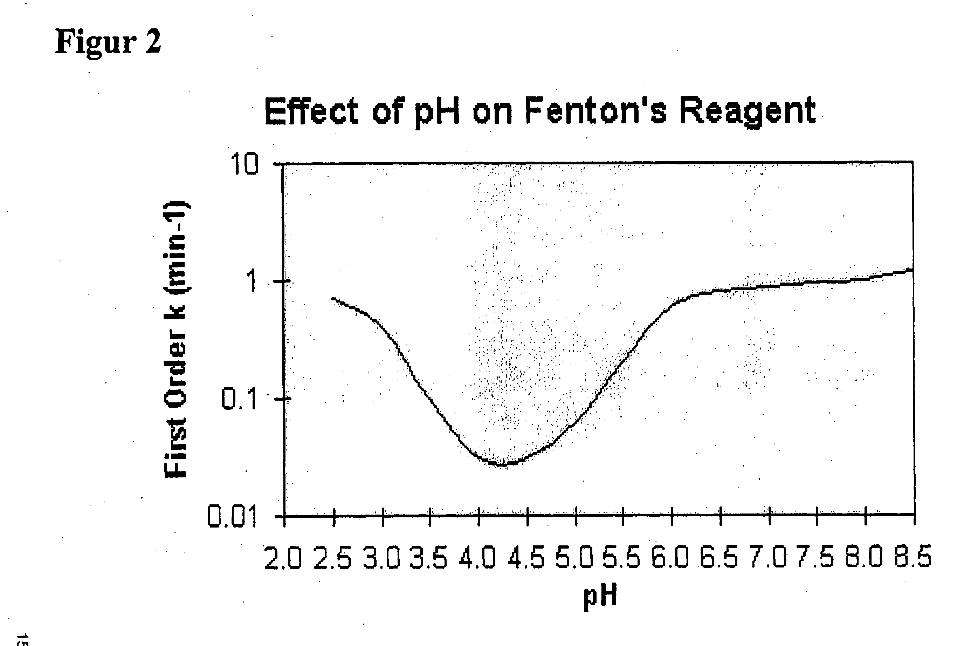

In diesem Zusammenhang ist insbesondere auf den Einfluss des pH-Werts im Laufe der Lag-Time-Messung hinzuweisen [22]. Nach Bishop *et al.* [19] und Millero *et al.* [20] führt ein pH-Wert-Anstieg bei der Fenton-Reaktion, insbesondere im pH-Wert-Bereich > 4,5, zu einer starken Beschleunigung der Hydroxylradikalgenerierung (siehe *Figur* 2). Es ist davon auszugehen, dass über eine Beschleunigung der Radikalgenerierung auch das vorliegende EAP eines Bieres schneller verbraucht wird und der Lag-Time-Wert einer Bierprobe entsprechend abnimmt.

In *Figur 3* sind entsprechende Messergebnisse von Bierproben mit unterschiedlichen pH-Ausgangswerten dargestellt [16, 21]. Wie in *Figur 3* gezeigt, ändert sich der aus den Kurvenverläufen bestimmte Lag-Time-Wert deutlich mit dem pH-Ausgangwert des Bieres: Bei einem pH-Wert von 4,32 (Kurve (a)) beträgt die Lag-Time 46,7 min, während sie bei einem pH-Wert von 4,03 (Kurve (b)) 53,2 min beträgt. Zudem wird eine Änderung des Steigunsverhaltens der Kurven und der erreichten Endkonzentration der Spin-Addukte beobachtet. Da der pH-Ausgangswert bei allen Bierproben unter 4,35 (< 4,5) liegt (vgl. *Figur* 3), d.h. die pH-Werte in einem Bereich vorliegen, in dem eine Radikalgenerierung relativ langsam erfolgt (siehe *Figur* 2), lässt sich der Gesamtzusammenhang erst verstehen, wenn der entscheidende Einfluss der Spin-Trap-Reagenz PBN auf die Lag-Time-Messung berücksichtigt wird.

Beispiel 4: *Einfluss des Spin-Trap-Reagenzes PBN auf den pH-Wert-Verlauf während der Lag-Time-Messung*

Die Erklärung für die Abweichung der Lag-Time-Werte in *Figur 3* ergibt sich grundlegend aus einem durch das Spin-Trap-Reagenz PBN [22] hervorgerufenen pH-Wert-Effekt auf die Lag-Time-Messung (pH-Wert-Effekt im Forciertest bei 60 °C).

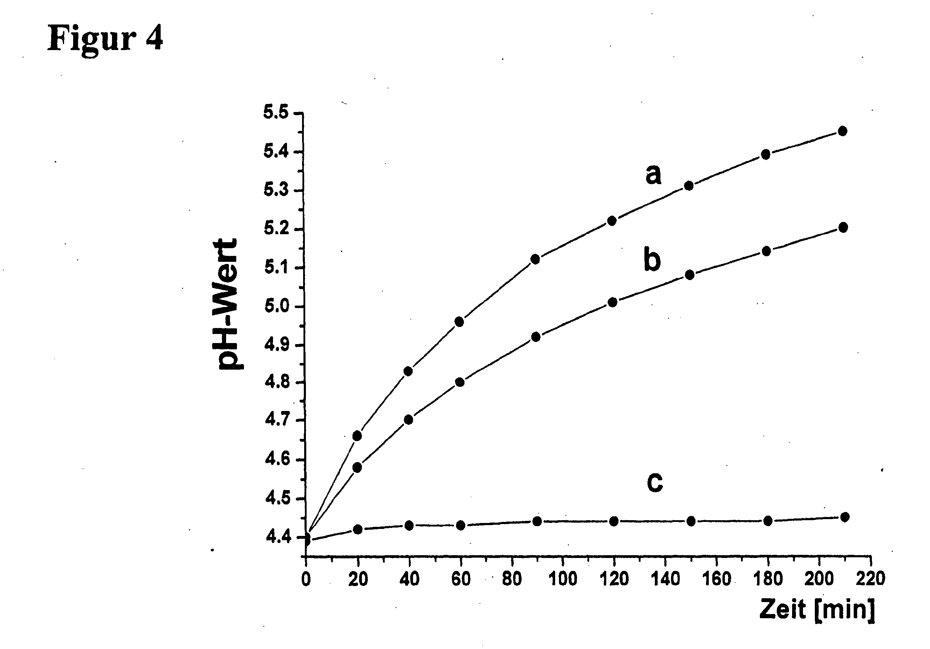

Wie aus den Messergebnissen in *Figur* 4, Kurven (a) und (b) hervorgeht, führt dieser pH-Wert-Effekt dazu, dass der pH-Wert einer Bierprobe über den Gesamtzeitraum der Lag-Time-Messung in Abhängigkeit von der eingesetzten PBN-Konzentration ansteigt. Daher liegen die pH-Werte der Bierproben bei einer PBN-Konzentration von 50 mM (Kurve (a)) bzw. 30 mM (Kurve (b)) am Ende der Lag-Time-Messung (210 min) um 1 bzw. 0,75 pH-Wert-Punkte über dem pH-Wert der Bierprobe ohne PBN-Zugabe (pH 4,45; Kurve (c)).

Die Messungen haben außerdem gezeigt, dass der pH-Wert-Anstieg praktisch unabhängig vom vorliegenden EAP eines Bieres ist, d.h. er wird ausschließlich von der eingesetzten PBN-Konzentration verursacht und kann durch eine Reaktion des PBNs unter Verbrauch von $H^+$-Ionen bzw. unter Bildung von $OH^-$-Ionen erklärt werden.

Es handelt sich dabei um eine Reaktion, bei der die für die Stabilisierung von Radikalen zur Verfügung stehende PBN-Konzentration über eine Inaktivierungsreaktion im gewissen Maße herabgesetzt wird. Sie hat ihre Ursache sehr wahrscheinlich in einer Hydrolyse (Benzaldehydbildung [22]) bzw. einer Adduktbildung nach vorheriger Protonierungsreaktion. Hierbei ist der stetig steigende Benzaldehydgeruch im Laufe der Lag-Time-Messung ein Indiz dafür, wieviel von der eingesetzten Menge an PBN über die Inaktivierungsreaktion verbraucht wurde. Die Inaktivierungsreaktion wird von verschiedenen Parametern, wie z.B. Temperatur, pH-Wert und PBN-Konzentration beeinflusst. Da die PBN-Zugabe die Radikalgenerierung über den pH-Wert konzentrationsabhängig verändert, wird das EAP eines Bieres unterschiedlich schnell verbraucht und der ermittelt Lag-Time-Wert entfernt sich in Abhängigkeit von der PBN-Zugabe und dem pH- Ausgangswert entsprechend weit von dem eigentlichen EAP eines Bieres, d.h. das EAP eine Bieres wird entsprechend stark verfälscht wiedergegeben.

Beispiel 5: *Einfluss der PBN-Konzentration auf den Lag-Time-Wert*

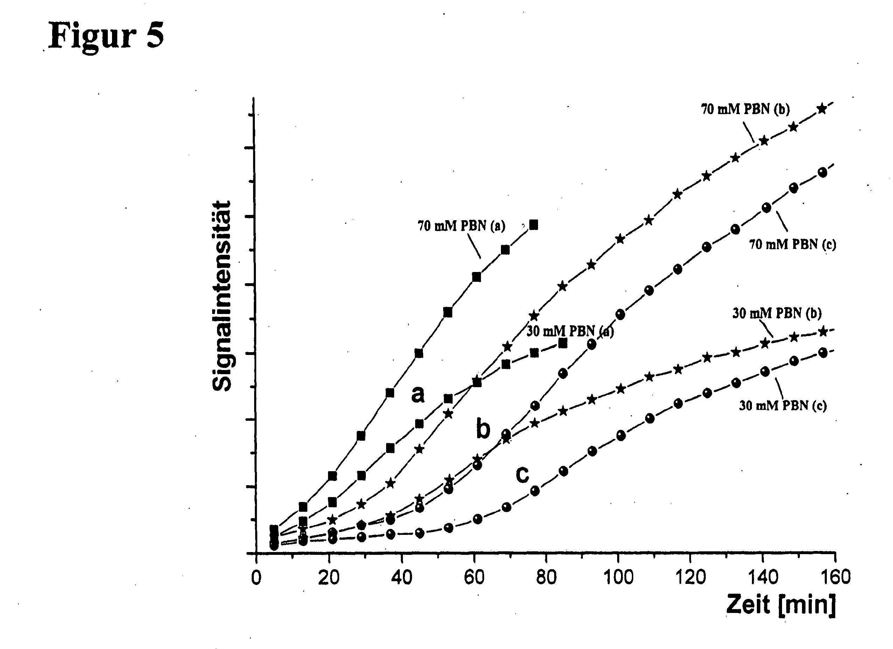

Dass ein Zusammenhang zwischen der gemessenen Lag-Time und der eingesetzten PBN-Konzentration besteht, wurde schon von Uchida, M. *et al.* [1] aufgezeigt. Je höher die PBN-Konzentration in einer Bierprobe ist, desto kleiner wird der gemessene Lag-Time-Wert *(Figur 5)*.

Würde eine bestimmte PBN-Konzentration immer einen bestimmten Lag-Time-Verlust hervorrufen, so könnte diese Abweichung von den tatsächlichen Verhältnissen im Bier toleriert werden, d.h. der richtige Wert wäre berechenbar.

Die Messergebnisse in *Figur* 5 zeigen jedoch auf, dass der durch eine bestimmte PBN-Konzentration hervorgerufene Lag-Time-Verlust, im Gegensatz zum pH-Wert-Anstieg (vgl. *Figur 4),* zusätzlich von dem vorliegenden EAP eines Bieres abhängt. Bei älteren Bieren mit niedrigem EAP und dementsprechend niedrigen Lag-Time-Werten ist der Unterschied, der durch eine höhere PBN-Konzentration (70 mM im Vergleich zu 30 mM) hervorgerufen wird, noch relativ gering *(Figur 5,* Kurve (a)). Vergleicht man dieses Ergebnis mit Bierproben, die ein höheres EAP aufweisen *(Figur 5,* Kurven (b) und (c)), wird ersichtlich, dass der durch die höhere PBN-Konzentration hervorgerufene Unterschied in der Lag-Time zunimmt. Folglich entfernt man sich nicht nur mit steigender PBN-Konzentration von den tatsächlichen Verhältnissen im Bier, sondern auch in Abhängigkeit vom vorliegenden EAP einer Bierprobe.

Dies lässt sich damit erklären, dass der Einfluß des pH-Werts auf die Radikalgenerierung aufgrund des stetig steigenden pH-Werts im Laufe der Lag-Time-Messung innerhalb der Lag-Time unterschiedlich ist. Während der pH- Wert bei einer PBN-Konzentration von 50 mM innerhalb einer Lag-Time von 20 min lediglich um 0,26 auf 4,66 ansteigt, liegt nach 60 min schon ein pH-Wert-Anstieg von 0,56 auf 4,96 vor *(Figur 4).* Folglich wird die Radikalgenerierung innerhalb einer hohen Lag-Time länger und stärker - höherer pH-Wert - in Richtung einer vermehrten Hydroxylradikalbildung beeinflusst. Das vorhandene EAP eines Bieres wird dadurch - relativ - schneller verbraucht, und die gemessene Lag-Time weicht immer weiter von den eigentlichen Verhältnissen im Bier ab (0 mM PBN).

Aus dem direkten Vergleich der pH-Wert-Entwicklung bei einer PBN-Konzentration von 50 mM bzw. 30 mM *(Figur 4,* Kurven (a) und (b)) wird außerdem deutlich, dass der Unterschied im pH-Wert zwischen verschiedenen PBN- Konzentrationen im Laufe der Lag-Time-Messung größer wird. Diese unterschiedliche pH-Wert-Entwicklung und der zeitlich längere Einfluss höherer pH-Werte bei steigenden Lag-Time-Werten sind dafür verantwortlich, dass die gemessenen Lag-Time-Unterschiede bei verschiedenen PBN-Konzentrationen immer stärker divergieren *(Figur 5).*

Bei Bierproben, die sich durch eine mittlere bis hohe oxidative Bierstabilität auszeichnen, können die beschriebenen Abweichungen zwischen dem gemessenen Lag-Time-Wert und den eigentlichen Verhältnissen im Bier bis zu 600 % betragen. Dies ist kein vernachlässigbarer Wert, vielmehr muss man von einer wesentlichen Beeinflussung sprechen.

Zur Veranschaulichung sind in *Figur 6* die Messergebnisse für eine Bierprobe mit einer mittleren bis hohen oxidativen Bierstabilität bei unterschiedlichen PBN-Konzentrationen (50, 10, 5 mM) im Forciertest bei 63°C dargestellt. Für Biere mit einer höheren oxidativen Bierstabilität lassen sich bei einer PBN-Konzentration von 5 mM keine Lag-Time- Werte realisieren (Inaktivierungsreaktion). Schon für den mittleren bis hohen Lag-Time-Bereich ergibt sich zwischen einer PBN-Konzentration von 50 mM (Lag-Time = 82 min - Ausganswert) und einer PBN-Konzentration von 5 mM (Lag- Time = 201 min) ein Unterschied von 119 min (145 %).

Es hat sich dennoch gezeigt, dass unter Einhaltung gleicher Messbedingungen und der Verwendung von Bierproben mit gleichem EAP (z.B. gleiche Abfüllung) im Bereich kleiner bis mittlerer Lag-Time-Werte die Einflüsse verschiedener Bierinhaltsstoffe auch mit der von Kaneda *et al.* [12] und Uchida *et al.* [1] entwickelten Messmethode aufzuzeigen sind. Allerdings ist der direkte Vergleich des EAPs unterschiedlicher Biersorten, die evtl. noch unterschiedliche pH-Ausgangswerte und unterschiedliche Alkoholgehalte aufweisen, als problematisch anzusehen und kann auch in diesem Bereich zu Fehlinterpretationen führen.

Bei Bieren mit einer mittleren bis hohen oxidativen Bierstabilität ist die Beschleunigung der Radikalgenerierung über den durch das Spin-Trap-Reagenz PBN verursachten pH-Wert-Effekt *(Figur 4, Figur* 5) so signifikant, dass es nicht mehr möglich ist, die eigentlichen Unterschiede in der oxidativen Bierstabilität verschiedener Biere mittels der Lag-Time-Werte darzustellen bzw. zu bewerten. Die Lag-Time-Messung in der bisherigen Form ist deshalb ungeeignet, das EAP eines Bieres wiederzugeben.

Beispiel 6: *Identifizierung eines geeigneten Spin-Trap-Reagenzes*

Da die ESR-Spektroskopie die einzige Messmethode ist, mit der die Radikale im Bier direkt nachgewiesen werden können, war es erforderlich, eine Methode zu entwickeln, die die Eigenschaften der ESR nutzt, um die im Bier vorliegende Radikalgenerierung direkt und unverfälscht aufzuzeigen.

Aus einer Vielzahl von Messreihen konnte POBN (4-POBN, N-*tert*-Butyl-$\alpha$-(4-pyridyl)-nitron-N-oxid) aus den handelsüblichen Spin-Trap-Reagenzien selektiert werden. POBN wurde schon vor mehreren Jahren für den Einsatz bei der Lag-Time-Messung überprüft, aber aufgrund seiner hohen Affinität zu den Hydroxyethylradikalen und seiner im Vergleich zu PBN geringeren Affinität zu den Hydroxylradikalen als ungeeignet eingestuft [z.B. 17]. Basierend auf den Ergebnissen in Bezug auf die Stabilität der Spin-Trap-Addukte von Hydroxyl- und Hydroxyethylradikalen und in ihrem daraus resultierenden Anteil am Gesamtspektrum beim Forciertest (60 °C) (ESR-Signal wird hauptsächlich durch "getrappte" Hydroxyethylradikale anstelle von Hydroxylradikalen verursacht), nutzt das Verfahren der vorliegenden Erfindung genau diese früher als nachteilig beurteilten Eigenschaften des POBN aus, um den EAP-Wert zu bestimmen.

Das erfindungsgemäße Verfahren der EAP-Bestimmung basiert im Wesentlichen auf dem Einsatz besser geeigneter Spin-Trap-Reagenzien, vorzugsweise POBN, und außerdem auf einer veränderten Temperatur während der forcierten Bieralterung (Temperaturbereich $\geq$ 40 °C, bevorzugt $\geq$ 60 °C, stärker bevorzugt 63-65 °C, optimal 63 °C).

Das Prinzip beruht hierbei in einem höheren Maße als bisher auf dem indirekten Nachweis der Radikalgenerierung im Bier mittels der sehr hohen Affinität des Spin-Trap-Reagenzes POBN gegenüber den sekundären Radikalen, insbesondere Hydroxyethylradikalen (eine um den Faktor 15-20 höhere Reaktionsgeschwindigkeit: POBN 3,1 $\cdot$ 10$^7$ M$^{-1}$s$^{-1}$[23]; PBN 1,5 $\cdot$ 10$^6$ M$^{-1}$s$^{-1}$[23]), die hauptsächlich aus den radikalischen Reaktionen der primären Sauerstoffradikalspezies ($O_2^-\bullet$; $OH\bullet$; $H\bullet$; $HO_2\bullet$) mit den Getränkeinhaltsstoffen, vorzugsweise Alkoholen entstehen. Auf diese Weise ist es möglich, die erforderliche Spin-Trap-Konzentration auf einen Bruchteil der bisherigen Konzentration zu senken. Diese Tatsache kann in Kombination mit der höheren Stabilität des Spin-Trap-Reagenzes POBN und seiner Spin-Addukte gegenüber der den pH-Wert verändernden Inaktivierungsreaktion bei gleichzeitiger gezielter Anpassung der Analysenparameter an die speziellen Eigenschaften des POBN genutzt werden, um den bei der bisher verwendeten Messmethode vorliegenden pH-Wert-Effekt auf die Radikalgenerierung zu umgehen und das eigentliche, "wahre" EAP einer Probe zu bestimmen.

Da POBN außerdem direkt im Bier löslich ist, kann die zusätzliche Beeinflussung der Messergebnisse über eine Ethanolzugabe,. beispielsweise hervorgerufen durch das bisher übliche Lösen von PBN in einer Ethanollösung, ausgeschlossen werden.

Das letztendliche Kriterium für das EAP in einer Probe unter definierten experimentellen Bedingungen bildet ein über den Zeitpunkt der ungehinderten Radikalgenerierung in der Probe ermittelter Wert (EAP-Wert).

Im Gegensatz zu der bisherigen Bestimmungsmethode mittels PBN, die ungeeignet ist, das EAP eines Biers unverfälscht darzustellen, kann die hohe Aussagekraft und Auflösung der neuen EAP-Bestimmung in Zukunft zur realistischen Beschreibung der oxidativen Bierstabilität herangezogen werden und erlaubt es, die Einflüsse der Inhaltsstoffe als solche detailliert aufzuzeigen.

In *Figur* 7 sind die Messergebnisse für die POBN- und PBN-Spin-Addukte in einem speziellen radikalgenerierenden Fenton-System (0,1 M Phosphat-Puffer, pH 4, vgl. auch *Figur 1A*) dargestellt.

Der Verlauf der Kurve (a) in *Figur* 7 zeigt, dass die nach der Radikalgenerierung (starker Anstieg während der Injektion bis "E") gebildeten, stabilisierten PBN-OH•-Addukte innerhalb einer Minute fast vollständig zerfallen sind, während die POBN-OH•-Addukte (Kurve (b)) eine um den Faktor $\approx$ 12 höhere Stabilität aufweisen.

Die höhere Stabilität der mittels POBN stabilisierten Hydroxylradikale kann zwar nicht äquivalent auf die Verhältnisse in einer Bierprobe übertragen werden, dennoch macht sie sich im Rahmen einer EAP-Bestimmung bemerkbar. Der daraus resultierende Anteil an stabilisierten Hydroxylradikalen im Gesamtspektrum kann im Laufe der EAP-Bestimmung, insbesondere im unteren Kurvenverlauf (Anteil der instabilen Spin-Trap-Addukte am Gesamtspektrum noch relativ hoch), zu einer gewissen Streuung der Signalmaxima führen.

Diese Streuung kann vermieden bzw. vermindert werden, indem man zwischen der Probennahme und der eigentlichen Messung einen Zeitpuffer von ca. 3-4 min einplant. In dieser Zeit reagieren die meisten instabilen POBN-Spin-Addukte aus, und die Signalintensität wird auch im unteren Kurvenverlauf hauptsächlich durch die stabilen POBN-$C_2H_5O\bullet$-Spin-Addukte bestimmt. Die entsprechende Reaktion lässt sich anhand einer ESR-Spektren-Aufnahme über mehrere Scans zu Beginn einer EAP-Bestimmung, nachvollziehen (Messung direkt nach Probennahme in der Anfangsphase der EAP-Bestimmung, unterer Kurvenverlauf).

Aus dem direkten Vergleich der Messergebnisse unter Ethanolzugabe *(Figur* 7, Kurven (c), PBN, und (d), POBN) geht hervor, dass beide Spin-Trap-Reagenzien eine hohe Stabilität bei den "getrappten" Hydroxyethylradikalen aufweisen. Die größere Affinität des Spin-Trap-Reagenzes POBN zu den Hydroxyethylradikalen und die höhere Stabilität gegenüber der den pH-Wert verändernden Inaktivierungsreaktion spiegelt sich in einer höheren Gesamtkonzentration an Spin-Trap-Addukten wider *(Figur* 7, Kurven (c) und (d)). Analog verhält sich der anfängliche Anstieg der Signalintensität nach der Injektionphase ("E") durch zusätzliche Radikalbildung (Fenton-Reaktion).

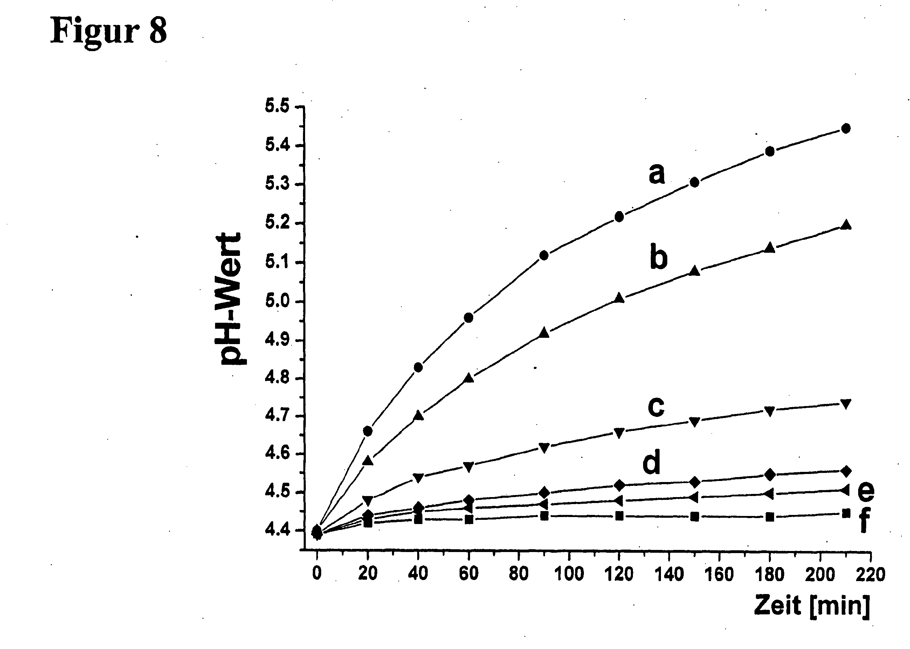

Die höhere Stabilität des Spin-Trap-Reagenzes POBN und seiner Spin-Addukte *(Figur 7,* Kurven (a), PBN, und (b), POBN) gegenüber der den pH-Wert verändernden Inaktivierungsreaktion wird noch deutlicher, wenn man den konzentrationsabhängigen pH-Wert-Verlauf beider Spin-Trap-Reagenzien während einer forcierten Bieralterung (60 °C) einander gegenüberstellt *(Figur 8).*

Die Ergebnisse in *Figur 8,* Kurven (b) und (c) ist zu entnehmen, dass der pH-Wert einer Bierprobe bei einer POBN-Konzentration von 30 mM im Vergleich zu 30 mM PBN geringeren Einflüssen unterliegt. Allein dieser Sachverhalt würde bei Einsatz von 30 mM POBN gegenüber der normalerweise eingesetzten Konzentration an PBN von 50 mM eine signifikante Annäherung an die im Bier vorliegenden Verhältnisse bedeuten. Dennoch wird auch bei einer POBN-Konzentration von 30 mM der kritische pH-Wert von 4,5 überschritten [19, 20]. Dies bedeutet, dass auch bei einer POBN-Konzentration von 30 mM nur eine verfälschte Wiedergabe der im Bier vorliegenden Verhältnisse möglich wäre. Weitere Messungen haben außerdem gezeigt, dass die hohe Affinität des Spin-Trap-Reagenz POBN gegenüber den Hydroxyethylradikalen dazu führt, dass bei einer Konzentration von 30 mM keine verwertbaren Ergebnisse vorliegen (zu schneller Anstieg der Spin-Trap-Addukt-Konzentration).

Erst die Kombination beider POBN-Eigenschaften macht es möglich, das EAP eines Bieres oder aber auch von beispielsweise Wein oder Fruchtsaft direkt und mit einer sehr hohen Empfindlichkeit nachzuweisen.

Zum einen wird die ca. 15-20-mal höhere Affinität zu den Hydroxyethylradikalen ausgenutzt, um die POBN-Konzentration auf eine Konzentration von vorzugsweise 3 mM ($\leq$ 10 mM) zu verringern. Dadurch lässt sich eine EAP-Bestimmung mit einer vergleichbaren Signalintensität der ESR-Spektren durchführen, die auch bei der bisherigen Lag-Time-Messung mit einer PBN-Konzentration von 50 mM erreicht wurde.

Zum anderen führt die höhere Stabilität gegenüber der den pH-Wert verändernden Inaktivierungsrektion dazu, dass der pH-Wert einer Bierprobe bei einer POBN-Konzentration von 3 mM gegenüber einer Bierprobe ohne POBN-Zugabe um weniger als 0,03 pH-Wert-Punkte ansteigt *(Figur 8,* Kurven (e), 5 mM POBN, und (f) 0 mM POBN). Da es sich außerdem um einen pH-Wert-Bereich (< 4,5) handelt, in dem keine nennenswerten Auswirkungen auf die Geschwindigkeit der Radikalgenerierung bestehen (siehe *Figur* 2), hat man praktisch die im Bier vorliegenden Verhältnisse erreicht.

Beispiel 7: *EAP-Bestimmung im Direktvergleich mit der Lag-Time-Messung*

Der oben diskutierte Befund spiegelt sich entsprechend in den Messergebnissen der EAP-Bestimmung wider.

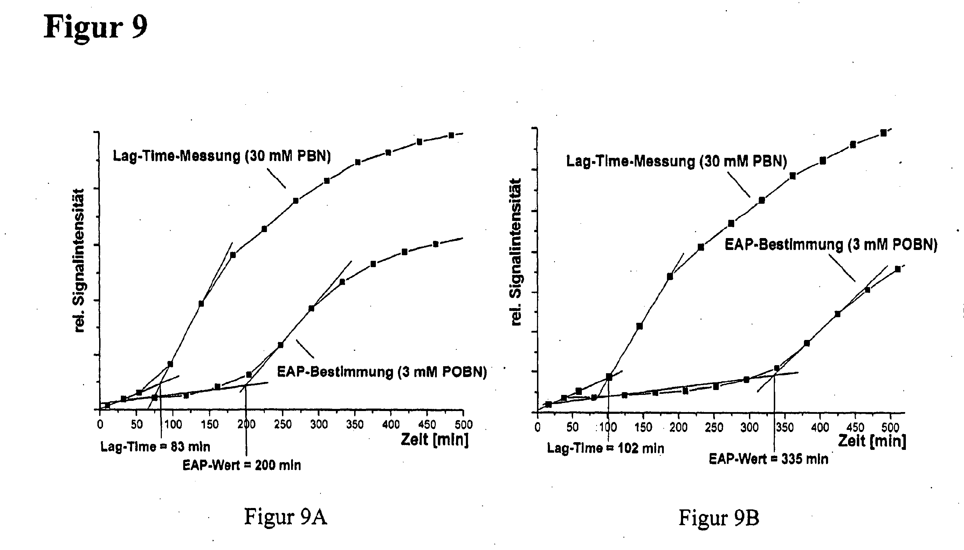

Aus den Messergebnissen in *Figur 9* wird der signifikante Unterschied zwischen der bisherigen Lag-Time-Messung und der EAP-Bestimmung für den Bereich der mittleren bzw. mittleren bis hohen oxidativen Bierstabilität ersichtlich. Schon im mittleren Bereich der oxidativen Bierstabilität *(Figur* 9) führt der durch das Spin-Trap-Reagenz PBN (30 mM) verursachte Einfluss auf die Radikalgenerierung dazu, dass der Lag-Time-Wert unter den Bedingungen des Forciertests (63 °C) um ca. 2 h von den "wahren" Verhältnissen im Bier abweicht. Bezogen auf den Lag-Time-Wert entspricht dies einer Abweichung von 242 % und ist für eine Analysenmethode nicht mehr zu tolerieren. Die im Bereich einer mittleren bis hohen oxidativen Bierstabilität *(Figur 9B)* vorliegende Abweichung von ca. 4 h (328 %) gegenüber den im Bier gemessenen Lag-Time-Werten zeigt auf, dass die bisherige Lag-Time-Messung für die Bestimmung des EAPs eines Bieres ungeeignet ist. Durch die Verwendung der normalerweise eingesetzten PBN-Konzentration von 50 mM wird diese enorme Diskrepanz aufgrund des schnelleren pH-Wert-Anstiegs zusätzlich verstärkt *(Figur 8)*. Messergebnisse für Biere mit einer sehr hohen oxidativen Bierstabilität lassen bei einer PBN-Konzentration von 50 mM Unterschiede von mehr als 8 h (mehr als 500 %) erkennen.

Im Gegensatz dazu spiegelt die EAP-Bestimmung die unverfälschten Verhältnisse im Bier in einer sehr hohen Auflösung wider und zeichnet sich durch eine hohe Aussagekraft der EAP-Werte aus.

Beispiel 8: *Lag-Time-Messung und EAP-Bestimmung in Abhängigkeit vom SO$_2$-Gehalt*

Die hohe Aussagekraft der EAP-Bestimmung kann dazu genutzt werden, um die grundlegenden radikalischen Reaktionen, die für die oxidative Bierstabilität von Bedeutung sind, und die Einflüsse der essentiellen Komponenten der oxidativen Bierstabilität, nämlich Sauerstoff und antioxidative Inhaltsstoffe (z.B. SO$_2$, Maillard-Reaktionsprodukte, Ascorbinsäure, Metallionen u.a.) zu beobachten und detailliert nachzuweisen.

In *Figur 10* ist ein Vergleich zwischen der gemessenen Lag-Time *(Figur 10A, B)* [13] und dem gemessenen EAP-Wert (*Figur 10 C, D)* in Abhängigkeit vom $SO_2$-Gehalt einer Bierprobe dargestellt.

Aus den Lag-Time-Werten in *Figur 10A* geht eine nicht-lineare Abhängigkeit des $SO_2$-Gehalts einer Bierprobe von der oxidativen Bierstabilität hervor. Die in mehreren Publikationen [z.B. 11] bestätigte Abhängigkeit vom $SO_2$-Gehalt lässt sich eher über eine Sättigungskurve beschreiben. Die Ergebnisse der EAP-Bestimmung *(Figur 10C, D)* widersprechen dieser Theorie grundlegend. Aus der EAP-Bestimmung wird vielmehr deutlich, dass in Wirklichkeit ein annähernd linearer Zusammenhang zwischen dem $SO_2$-Gehalt einer Bierprobe und der oxidativen Bierstabilität besteht.

Um die stark unterschiedlichen Ergebnisse erklären zu können, ist auch in diesem Zusammenhang auf den durch das Spin-Trap-Reagenz PBN verursachten pH-Wert-Effekt hinzuweisen, der einer linearen Abhängigkeit zwischen der gemessenen Lag-Time und dem $SO_2$-Gehalt eines Bieres entgegensteht. Zwar steigen die Lag-Time-Werte mit steigendem $SO_2$-Gehalt der Bierprobe an, aber ebenso werden die Auswirkungen des pH-Wert-Effekts auf die Radikalgenerierung mit steigenden Lag-Time-Werten größer *(Figuren 4* bis *6, Figur 8),* und die Lag-Time entfernt sich immer weiter von den im Bier tatsächlich vorliegenden Verhältnissen.

Vergleicht man den Lag-Time-Wert von 85 min bei einem $SO_2$-Gehalt von 11,5 mg/l mit dem EAP-Wert von 335 min bei einem $SO_2$-Gehalt von 11,2 mg/l, so wird die bei der Lag-Time-Messung vorliegende signifikante Verfälschung der Ergebnisse mit ca. 4,2 h mehr als deutlich. In *Figur 10B* ist zusätzlich eine Messung mit einem sehr hohen $SO_2$-Gehalt der Bierprobe von 53,3 mg/l dargestellt. Der gemessene Lag-Time-Wert (156 min) diente lediglich dazu, den Verlauf der Abweichung ungefähr abzuschätzen.

Der hohe $SO_2$-Gehalt von 53,3 mg/l kann zwar für deutsche Biere als unrealistisch angesehen werden, ist aber im Zusammenhang mit anderen Getränken, die ein EAP aufweisen, insbesondere Weine, von besonderem Interesse. Aufgrund der logisch nachvollziehbaren linearen Abhängigkeit des EAPs vom $SO_2$-Gehalt eines Getränks lassen sich für solche Getränke Abweichungen von bis zu 1000% prognostizieren. Das bedeutet, dass die z.B. beim Wein gemessenen Lag-Time-Werte im Gegensatz zur landläufigen Meinung ungeeignet sind, das eigentliche EAP aufzuzeigen.

Weitere EAP-Bestimmungen haben außerdem erkennen lassen, dass verschiedene Biere mit gleichem $SO_2$-Gehalt unterschiedliche EAP-Werte aufweisen. Dies lässt sich damit begründen, dass, über die signifikante und lineare Abhängigkeit der EAP-Werte vom $SO_2$-Gehalt hinaus, andere Bierinhaltsstoffe (Metallionen in ihrer Wirkungsweise über die Fenton- und Haber-Weiss-Reaktion, Maillard-Reaktionsprodukte, phenolische Inhaltsstoffe etc.) an der oxidativen Bierstabilität beteiligt sind. Außerdem wird die Geschwindigkeit der Radikalgenerierung über den originären pH-Ausgangswert der Getränkeprobe beeinflusst (siehe *Figur 2).*

Beispiel 9: *EAP-Bestimmung in Saft und Wein*

Aus den *Figuren 13* bis *19* geht hervor, dass die EAP-Bestimmung auch dazu eingesetzt werden kann, um das EAP anderer Getränke (z.B. in Saft oder Wein) nachzuweisen. Gegenüber dem Bier führt im Saftbereich insbesondere die Ascorbinsäurezugabe (Vitamin C) zu sehr hohen EAP-Werten, während die hohen EAP-Werte im Weinbereich *(Figur 18)* weitestgehend auf die höheren $SO_2$-Gehalte im Wein zurückzuführen sind.

Der Direktvergleich von *Figur 14* und *Figur 15* gibt erste Hinweise darauf, dass neben der Ascorbinsäure auch die anderen Vitamine in einem Saft (z.B. Multivitaminsaft) am EAP beteiligt sind. Dies konnte durch zusätzliche Messungen mit Karottensäften bestätigt werden, bei denen insbesondere das Provitamin A für ein gewisses EAP verantwortlich ist. D.h. auch in diesem Bereich ist die EAP-Bestimmung prädestiniert, die Auswirkungen bestimmter Getränkeinhaltsstoffe auf das EAP aufzuzeigen.

Bei den Biermixgetränken, die z.B. "Fresh Lemon"-Limonade enthalten *(Figur 20),* wird das EAP im Wesent-lichen durch den $SO_2$-Gehalt des Bieres und den Ascorbinsäuregehalt der "Fresh Lemon"-Limonade bestimmt. Beide Inhaltsstoffe führen bei diesen Mixgetränke zu entsprechend hohen EAP-Werten.

Für Säfte ist eine EtOH-Zugabe von 0-5 Vol.-% zu empfehlen (vorzugsweise 3.-Vol %). Dadurch wird eine höhere Signalintensität bei den "getrappten" Sekundärradikalen erreicht und die Auswertung erleichtert, ohne den EAP-Wert wesentlich zu beeinflussen. Zum direkten Vergleich verschiedener Säfte sind die einmal festgelegten Parameter (Temperatur, Forciertest, EtOH-Zugabe etc.) für alle Messungen einzuhalten (Forciertest 60°C empfohlen). Bei naturtrüben Säften mit sehr hohem Fruchtanteil ist eine Zentrifugation der Saftproben erforderlich (5000 U/min, 5 min).

Beispiel 10: *Praktische Anwendung*

Mit Hilfe des erfindungsgemäßen Verfahrens lassen sich nicht nur die Einflüsse der verschiedenen Inhaltsstoffe aufzeigen. Durch eine neue Kenngröße, die man z.B. als "Beverage Antioxidant Index" (kurz BAX) bezeichnen könnte, lassen sich auch die Charakteristika verschiedener Sorten von Bier (Pils, Export etc.) und anderen Getränke, wie etwa Wein oder Saft, besser beschreiben.

Aufgrund der nachgewiesenen linearen Abhängigkeit der EAP-Werte vom $SO_2$-Gehalt ist es möglich, durch entsprechende Zudotierung die Zunahme des EAP-Werts bezogen auf 1 mg $SO_2$-Gehalt zu ermitteln, um so die neue Kenngröße zu bestimmen. Diese Kenngröße macht die Auswirkungen zusätzlicher Faktoren auf die oxidative Stabilität von Bier und anderen Getränken, (Metallionen, pH-Wert der Probe, andere oxidativ wirkende Inhaltsstoffe etc.) in ihrer Gesamtheit zugänglich. So können beispielsweise die Charakteristika verschiedener Biersorten in ihrem antioxidativen Verhalten und die Unterschiede einzelner Biere untereinander aufgezeigt werden.

Allgemein, d.h. in diesen Fällen und allen anderen Getränken, empfiehlt sich die Zudotierung von $SO_2$, z.B. durch $Na_2SO_3$. Die Kenngröße $BAX_{(sp)}$ lässt sich dann anhand folgender Beziehung ermitteln:

$$BAX_{(sp)} = \Delta\ EAP/\Delta\ SO_2\text{-Gehalt}_{(sp)}\ [min \cdot l/mg]$$

Dabei steht "sp" für "spiked", d.h. nach Zudotierung, und $\Delta$ EAP ist der EAP-Wert nach $SO_2$-Zudotierung minus gemessener (endogener) EAP-Wert in der Probe.

Für viele Biere, bei denen das EAP hauptsächlich durch den $SO_2$-Gehalt vorgegeben ist, lässt sich diese Kenngröße in einer ersten Annäherung durch den Quotienten zwischen gemessenem (ermitteltem) EAP-Wert in der Probe und dem Gesamtgehalt an $SO_2$ ermitteln:

$$BAX = EAP_{(gesamt)}/SO_2\text{-Gehalt}_{(gesamt)}\ [min \cdot l/mg]$$

Die nachgewiesene lineare Abhängigkeit des EAP-Werts vom $SO_2$-Gehalt eines Bieres ist für verschiedene Biere unterschiedlich stark ausgeprägt (Steigung). Die $BAX_{(Sp)}$-Werte der meisten Biere liegen zwischen 50 und 25 min/mg $SO_2$-Gehalt.

Der daraus resultierende Wert macht die zusätzlichen Faktoren der oxidativen Bier- bzw. Getränkestabilität in ihrer Gesamtheit zugänglich. So wird ein Bier mit einer niedrigeren Metallionenkonzentration, einem niedrigeren pH-Wert und einer höheren Konzentration an antioxidativen Inhaltstoffen eine höhere oxidative Biers- bzw. Getränkestabilität pro mg $SO_2$/l (EAP-Wert/$SO_2$-Gehalt) aufweisen.

Da sich der $SO_2$-Gehalt eines Bieres über die Steuerung des Gärungsprozesses nur individuell begrenzt erhöhen lässt und in Deutschland ein Grenzwert von 10 mg/l vorgegeben ist, sollte es das Ziel entsprechender brautechnischer Maßnahmen sein, die zuvor beschriebene Größe zu steigern, um eine nachhaltige Verbesserung in der oxidativen Bierstabilität zu erreichen. Außerdem ermöglicht das erfindungsgemäße Verfahren, die Einflüsse der einzelnen Zwischenstufen des Brauprozesses auf das EAP darzustellen (z.B. Gärung, Lagertank, chemischphysikalische Bierstabilisierung, Filtrationsstufen, Abfüllung).

In *Figur 11* ist dies am Beispiel der Auswirkungen der chemisch-physikalischen Bierstabilisierung (Eiweißstabilisierung durch Silica-Gel und PVPP-Stabilisierung durch Entzug eines Polyphenolanteils) dargestellt.

Bei der Lag-Time-Messung (PBN in *Figur 11A*) lassen sich zwar unterschiedliche Endkonzentrationen an Spin-Trap-Addukten feststellen, aber die Lag-Time-Werte als Kriterium des EAPs zeigen keine erkennbaren Unterschiede. Im Gegensatz dazu lassen sich bei der EAP-Bestimmung (3 mM POBN in *Figur 11B*) nicht nur die unterschiedlichen Endkonzentrationen an Spin-Trap-Addukten erkennen, sondern gleichzeitig die Einflüsse einzelner Prozessstufen auf das EAP nachweisen. Ohne näher auf die daraus gewonnenen Erkenntnisse einzugehen, machen die Messungen in *Figur 11B* das in der EAP-Bestimmung liegende Potential für diesen Anwendungsbereich deutlich. Aus dem Direktvergleich der Kurvenverläufe in *Figur 11A* und *Figur 11B* geht auch hervor, wie stark das eigentliche EAP *(Figur 11B)* bei dieser Bierprobe durch die PBN-Zugabe (Lag-Time-Messung) verfälscht wird (ca. 300-350 min → 300-350% Abweichung) und kein Zusammenhang zwischen dem Lag-Time-Wert und dem eigentlichen EAP herzustellen ist.

Ein weiterer Anwendungsbereich für die EAP-Bestimmung ergibt sich direkt aus dem Ein-fluss der Verpackungsmaterialien auf die oxidative Bierstabilität. Eine Umgehung des pH-Wert-Effekts führt insbesondere im oberen EAP-Wert-Bereich zu einer signifikant höheren Auflösung der Ergebnisse. Daher ist die EAP-Bestimmung prädestiniert, die durch die Sauerstoffpermeation über die verschiedensten Verpackungsmaterialien (z.B. Kronenkorken, Kronenkorken mit $O_2$-Scavengereigenschaften, Bügelverschlusstypen, Kunststoffflaschen aus PET oder PEN etc.) hervorgerufenen Einflüsse auf die oxidative Bierstabilität mit einer hohen Genauigkeit aufzuzeigen. Aufgrund der beschriebenen Eigenschaften ist es vorherzusehen, dass die EAP-Bestimmung in Zukunft auch im Bereich der Verpackungsmaterialien an Bedeutung gewinnen wird.

Nicht zuletzt wird für die EAP-Bestimmung der vorliegenden Erfindung nur ein Bruchteil der bisherigen Spin-Trap-Konzentration benötigt (< 3,5 mM anstatt 50 mM). Dadurch können die nicht unerheblichen Kosten im Bereich der Spin-Trap-Reagenzien um 80 % reduziert werden. Dies entspricht einer Kostenreduzierung von 12.000-15.000 Euro pro Jahr und Brauerei (bei routinemäßigen Einsatz: ca. 40 Messungen/Woche; Kostenreduzierung/Messung ca. 7 Euro; ca. 50 Wochen/Jahr; Ersparnis 12.000-15.000 Euro/Jahr).

Für die Brauereien, bei denen in Zukunft die EAP-Bestimmung routinemäßig eingesetzt wird, ergibt sich, über die höhere Aussagekraft der EAP-Werte hinaus, nicht nur die Möglichkeit, Abweichungen im Brauprozess rechtzeitig zu erkennen und gezielt einzugreifen, sondern zusätzlich eine merkliche Kostenreduzierung im Bereich der Qualitätskontrolle und -sicherung.

Literaturverzeichnis

1 UCHIDA, M.; ONO, M.: Improvement for Oxidative Flavor Stability of Beer - Role of OH-Radical in Beer Oxidation, J. Am. Soc. Brew. Chem. 54, 4, 198-204, 1996

2 UCHIDA, M.; SUGA, S.; ONO, M.: Improvement for Oxidative Flavor stability of Beer - Rapid Predicition Method for Beer Flavor Stability by Electron Spin Resonance Spectroscopy, J. Am. Soc. Brew. Chem. 54, 4, 205-211, 1996

3 STASKO, A.; RAPTA, P.; MALIK, F.: Charakterisierung der Bierstabilität mit Hilfe von Radikalfängern (eine EPR-studie), Monatsschrift für Brauwissenschaft, 53, 1/2, 4-7,2000

4 FORSTER, C.; SCHWEIGER, J.; NARZISS, L.; BACK, W.; UCHIDA, M.; ONO, M.; YANAGI, K.: Untersuchungen zur Geschmacksstabilität von Bier mittels Elektronenspinresonanz-Spektroskopie freier Radikale, Monatsschrift für Brauwissenschaft, 52, 5/6, 86-93, 1999

5 FORSTER, C.: Die antioxidative Aktivität von Bier - eine neue Methode zur Verbesserung der Geschmacksstabilität, Mitteilungen österreichisches Getränkeinstitut, 11/12, 132-139, 1998

6 YANAGI, K.; ISHIBASHI, Y.; OKA, K.; UCHIDA, M.: Neue Methoden zur Beurteilung von Geschmacksstabilität, Schaumeigenschaften und -stabilität von Bier, Brauwelt, 21/22, 841-859, 1997

7 ANDERSEN, M. L.; OUTTRUP, H.; SKIBSTED, H.: Potential Antioxidants in Beer Assessed by ESR Spin Trapping, J. Agr. Food Chem. 48, 8, 3106-3111, 2000

8 KANEDA, H.; OSAWA, T.; KAWAKISHI, S.; MUNEKATA, M.; KOSHINO,S.: Contribution of carbonyl-bisulfite adducts to beer stability, J. Agr. Food Chem. 42, 2428-2432, 1994

9 KANEDA, H.; MASACHIKA, T.; OSAWA, T.; KAWAKISHI, S.; TAMAKI, T.: Behavior of Sulfites during Fermentation and Storage of Beer, J. Am. Soc. Brew. Chem., 54, 2, 115-120, 1996

10 WALTERS, M. T.: Natural antioxidants and flavour stability, Ferment 10, 2, 111-119 1997

11 UCHIDA, M.; ONO, M.: Technological Approach to Improve Beer Flavor Stability: Analysis of the Effect of Brewing Processes on Beer Flavor Stability by the Electron Spin Resonance Method, J. Am. Soc. Brew. Chem. 58, 1, 8-13, 2000

12 KANEDA, H.; KANO, Y; OSAWA, T.; RAMARATHNAM, N.; KAWAKISHI, S.; KAMADA, K.: Detection of Free Radicals in Beer Oxidation, Journal of Food Science, 53, 885-888, 1988

13 KUNZ, T.; STEPHAN, A.; METHNER, F.J.; KAPPL, R.; HÜTTERMANN, J.: Grundlegendes zur Elektronenspinresonanz-Spektroskopie (ESR) und Untersuchungen zum Zusammenhang zwischen oxidativer Bierstabilität und dem SO2-Gehalt, Monatsschrift für Brauwissenschaft 55, No 7/8, 140-153, 2002

14 WACKERBAUER, K.; HARDT, R.: Radikalreaktionen und die Geschmacksstabilität des Bieres, Brauwelt, 40/41, 1880-1888, 1996

15 BACK, W.; FORSTER, C.; KROTTENTHALER, M.; LEHMANN, J.; SACHER, B.; THUN, B.: Neue Forschungserkenntnisse zur Verbesserung der Geschmacksstabilität, Brauwelt, 38, 1677-1692, 1997

16 KUNZ, T.: Untersuchungen zur oxidativen Bierstabilität mittels Elektronenspinresonanz (ESR), Diplomarbeit, FH Trier, 2002

17 ANDERSEN, M. L.; SKIBSTED, L. H.: Electron Spin Resonance Spin Trapping Identification of Radicals Formed during Aerobic Forced Aging of Beer, J. Agr. Food Chem., 46, 1272-1275, 1998

18 KUNZ, T.; KAPPL, R.; METHNER, F. J.; STEPHAN, A.; HÜTTERMANN, J.: Einfluss physiko-chemischer Parameter auf die Lag-Time Messung, in Vorbereitung

19 BISHOP, D.; STERN, G.; FLEISCHMANN, M.; MARSHALL, L.: Hydrogen Peroxide Catalytic Oxidation of Refractory Organics in Municipal Waste Water, I&EC Process Design and Development, 7, 110-117, 1968

20 MILLERO, F. J.; SOTOLONGO, S.; STADE, D. J.; VEGA, C. A.: Effect of Ionic Interactions on the Oxidation of Fe (II) with H2O2 in Aqueous Solutions, Journal of Solution Chemistry, Vol. 20, No. 11, 1079-1092, 1991

21 STEPHAN, A.; BIES, A; KUNZ, T.; METHNER, F. J.: Determination of antioxidants in brewing: Some aspects about the use of selected chemical and physical assays, European Brewery Convention, Monograph 31, Symposium Flavour and Flavour Stability, Nancy/France 2001, Fachverlag Hans Karl, Nürnberg

22 FRANZ, O.; BACK, W.: Erfahrungen zur Messung von freien Radikalen mittels Elektronenspinresonanz-Spektrometer in der Brauerei, Monatsschrift für Brauwissenschaft 55, No 7/8, 156-162, 2002

23 POU, S.; RAMOS C. L.; GLADWELL, T.; RENKS, E.; CENTRA, M.; YOUNG, D.; COHEN, M. S.; ROSEN, G. M.. A Kinetic Approach to the Selection of a Sensitive Spin Trapping System for the Detection of Hydroxyl Radical, Analytical biochemistry 217, 76-83, 1994

**Patentansprüche**

1. Verfahren zur Bestimmung eines endogenen antioxidativen Potentials (EAP) in einer Getränkeprobe ausgewählt aus der Gruppe, bestehend aus einer Probe von Bier, Wein, Saft und Mischungen davon, umfassend

   (a) Bereitstellen der Probe;
   (b) Hinzufügen des Spin-Trap-Reagenz POBN zu der Probe;
   (c) Durchführen der quantitativen Analyse eines mit dem Spin-Trap-Reagenz POBN stabilisierten sekundären Radikals unter Verwendung von ESR-Spektroskopie, wobei die Konzentration des POBN in der Probe ≤ 10 mM beträgt,
   wobei die Analyse das Durchführen eines Forciertest umfasst; und
   (d) Bestimmung des EAP-Werts.

2. Verfahren nach Anspruch 1, wobei die Konzentration des Spin-Trap-Reagenzes in der Probe 3 mM beträgt.

3. Verfahren nach Anspruch 1 oder 2, wobei das sekundäre Radikal ein Hydroxyethylradikal ist.

4. Verfahren nach Anspruch 1, wobei der Forciertest bei einer Temperatur im Bereich von ≥ 40 °C bis ≤ 96 °C, vorzugsweise im Bereich von ≥ 60 °C bis ≤ 96 °C, und besonders bevorzugt bei einer Temperatur von 63 °C durchgeführt wird.

5. Verfahren nach Anspruch 1, wobei der Forciertest bei einer Temperatur im Bereich von 63-65 °C bei Bier als Probe, 65-70 °C bei Wein als Probe und 60 °C bei Saft als Probe durchgeführt wird.

6. Verfahren nach einem der vorangehenden Ansprüche, wobei der Forciertest bei einem pH-Wert durchgeführt wird, der in einem Bereich liegt, der sich von einem pH-Wert-Punkt von 0,5 pH-Wert-Punkten unterhalb bis zu 0,5 pH-Wert-Punkten oberhalb des pH-Werts der Probe erstreckt, und der besonders bevorzugt dem pH-Wert der Probe entspricht.

7. Verfahren nach einem der vorangehenden Ansprüche, wobei der Forciertest in Gegenwart von Ethanol in einer Konzentration im Bereich von 0,01-20 Vol.-%, vorzugsweise im Bereich von 0,01-10 Vol.-%, stärker bevorzugt im Bereich von 0,01-6,0 Vol.-%, und besonders bevorzugt im Bereich von 0,01-3,0 Vol.-% durchgeführt wird.

8. Verfahren nach einem der vorangehenden Ansprüche, wobei das Durchführen der Analyse in Schritt (c) folgende Teilschritte umfasst:

    (c1) Entnahme einer Messprobe zu einer bestimmten Zeit;
    (c2) Aufnahme des ESR-Spektrums der Messprobe.

9. Verfahren nach Anspruch 8, wobei der Zeitraum zwischen den Teilschritten (c1) und (c2) $\leq$ 15 min, vorzugsweise 4 min beträgt.

10. Verfahren nach einem der vorangehenden Ansprüche, wobei das Verfahren ein die Radikalgenerierung förderndes System umfasst, wobei das die Radikalgenerierung fördernde System ein Fenton-System oder ein Röntgen-System ist,
wobei ein Fenton-System ein Reaktionssystem ist, in dem die Fenton-Reaktion unter experimentellen Bedingungen durch die Zusammenführung von Wasserstoffperoxid und Metallionen ($Fe^{2+}$) in unterschiedlichen Lösungen gezielt gestartet wird, und wobei mithilfe des Röntgen-Systems die künstliche Radikalgenerierung über ionisierende Röntgenstrahlung erfolgt.

11. Verfahren nach einem der vorangehenden Ansprüche, umfassend die qualitative und/oder quantitative Analyse des Einflusses einer oxidativ neutralen, antioxidativen oder oxidativen Verbindung auf das endogene antioxidative Potential der Probe,
wobei die Verbindung ausgewählt ist aus der Gruppe, bestehend aus Sauerstoff, $SO_2$, Maillard-Reaktionsprodukten, Ascorbinsäure und anderen Vitaminen, wie etwa Vitamin B oder Vitamin A, Metallionen, wie etwa $Fe2^+$ oder $Cu^+$, phenolischen Verbindungen, wie etwa Phenolcarbonsäuren, vorzugsweise Gallussäure, oder Flavonoiden, organischen Säuren, Proteinen, Polypeptiden, Aminosäuren, Alkoholen, wie etwa Ethanol, und Salzen, wie etwa $CaCl_2$.

12. Verfahren nach einem der vorangehenden Ansprüche, wobei der Probe $SO_2$ zudotiert und ein Quotient $BAX_{(sp)}$ aus dem Anstieg des endogenen antioxidativen Potentials EAP in der Probe und dem Probengehalt an $SO_2$ nach der folgenden Formel bestimmt wird:

$$BAX_{(sp)} = \Delta\ EAP/\Delta\ SO_2\text{-Gehalt}_{(sp)}\ [\text{min} \cdot \text{l/mg}]$$

wobei $\Delta$ EAP der EAP-Wert nach $SO_2$-Zudotierung minus EAP-Wert vor $SO_2$-Zudotierung ist, und wobei $\Delta$ $SO_2$-Gehalt der durch Zudotierung hervorgerufene $SO_2$-Gehalt ist.

13. Verfahren nach einem der Ansprüche 1 bis 11, wobei ein Quotient BAX aus dem gesamten endogenen antioxidativen Potential EAP in der Probe und dem Gesamtgehalt an $SO_2$ in der Probe nach der folgenden Formel bestimmt wird:

$$BAX = EAP_{(gesamt)}/SO_2\text{-Gehalt}_{(gesamt)}\ [\text{min} \cdot \text{l/mg}]$$

**Claims**

1. Method for determining the endogenous anti-oxidative potential (EAP) in a beverage sample selected from the group consisting of beer, wine, juice and mixtures thereof, comprising

    (a) Providing the sample;
    (b) Adding the spin trap reagent POBN to the sample;
    (c) Carrying out the quantitative analysis of a secondary radical stabilized with the spin trap reagent POBN using ESR spectroscopy, wherein the concentration of the POBN in the sample is $\leq$ 10 mM,
    wherein the analysis comprises performing a forcing test ("Forciertest"); and
    (d) Determining the EAP value.

2. The method according to claim 1, wherein the concentration of the spin trap reagent in the sample is 3 mM.

3. The method according to claim 1 or 2, wherein the secondary radical is a hydroxyethyl radical.

4. The method according to claim 1, wherein the forcing test is carried out at a temperature in the range from $\geq 40$ °C to $\leq 96$ °C, preferably in the range from $\geq 60$ °C to $\leq 96$ °C, and more preferably at a temperature of 63 °C.

5. The method according to claim 1, wherein the forcing test is carried out at a temperature in the range from 63-65 °C in case that beer is the sample, 65-70 °C in case that wine is the sample and 60 °C in case that juice is the sample.

6. The method according to any one of the preceding claims, wherein the forcing test is carried out at a pH value in a range spanning from a pH value point of 0.5 pH value points below the pH value of the sample up to 0.5 pH value points above the pH value of the sample, and that more preferably corresponds to the pH value of the sample.

7. The method according to any one of the preceding claims, wherein the forcing test is carried out in presence of ethanol in a concentration in the range from 0.01-20 vol.-%, preferably in the range from 0.01-10 vol.-%, more preferably in the range from 0.01-6.0 vol.-%, and even more preferably in the range from 0.01-3.0 vol.-%.

8. The method according to any one of the preceding claims, wherein the carrying out the analysis in step (c) comprises the following sub-steps:

    (c1) Sampling a test sample at a certain time;
    (c2) Recording the ESR spectrum of the test sample.

9. The method according to claim 8, wherein the time period between the sub-steps (c1) and (c2) is $\leq 15$ min, preferably 4 min.

10. The method according to any one of the preceding claims, wherein the method comprises a system promoting radical generation, wherein said system promoting radical generation is a Fenton system or an X-ray system, wherein a Fenton system is a reaction system, where the Fenton reaction is specifically started under experimental conditions via bringing together hydrogen peroxide and metal ions ($Fe^{2+}$) in different solutions, and wherein by using the X-ray system the artificial radical generation occurs via ionizing X-radiation.

11. The method according to any one of the preceding claims, comprising the qualitative and/or quantitative analysis of the influence of an oxidative neutral, antioxidative or oxidative compound on the endogenous anti-oxidative potential of the sample, wherein the compound is selected from the group consisting of oxygen, $SO_2$, Maillard reaction products, ascorbinic acid and other vitamins, such as vitamin B or vitamin A, metal ions, such as $Fe^{2+}$ or $Cu^+$, phenolic compounds, such as phenolic carboxylic acids, preferably gallic acid, or flavonoides, organic acids, proteins, polypeptides, amino acids, alcohols, such as ethanol, and salts, such as $CaCl_2$.

12. The method according to any one of the preceding claims, wherein $SO_2$ is doped to the sample, and a quotient $BAX_{(sp)}$ is determined from the increase of the endogenous anti-oxidative potential EAP in the sample and the sample content of $SO_2$ according to the following formula:

$$BAX_{(sp)} = \Delta \, EAP / \Delta \, SO_2 \, content_{(sp)} \, [min \cdot l/mg]$$

wherein $\Delta$ EAP is the EAP value after $SO_2$ doping minus EAP value before $SO_2$ doping, and wherein $\Delta$ $SO_2$ content is the $SO_2$ content caused by $SO_2$ doping.

13. The method according to any one of claims 1 to 11, wherein a quotient BAX is determined from the total endogenous anti-oxidative potential EAP in the sample and the total content of $SO_2$ in the sample according to the following formula:

$$BAX = EAP_{(gesamt)} / SO_2 \, content_{(total)} \, [min \cdot l/mg].$$

**Revendications**

1. Procédé de détermination d'un potentiel anti-oxydatif endogène (EAP) dans un échantillon de boisson choisi dans le groupe comprenant un échantillon de bière, de vin, de jus et de mélanges de ceux-ci, comprenant

    (a) la mise à disposition de l'échantillon ;
    (b) l'addition du réactif spin-trap POBN à l'échantillon ;
    (c) la réalisation de l'analyse quantitative d'un radical secondaire stabilisé avec le réactif spin-trap POBN en utilisant la spectroscopie ESR, dans lequel la concentration du POBN dans l'échantillon est ≤ 10 mM, dans lequel l'analyse comprend la réalisation d'un test de vieillissement ; et
    (d) la détermination de la valeur du PAE.

2. Procédé selon la revendication 1, dans lequel la concentration du réactif spin-trap dans l'échantillon est de 3 mM.

3. Procédé selon la revendication 1 ou 2, dans lequel le radical secondaire est un radical hydroxyéthyle.

4. Procédé selon la revendication 1, dans lequel le test de vieillissement est réalisé à une température dans la plage de ≥ 40 °C à ≤ 96 °C, de préférence dans la plage de ≥ 60 °C à ≤ 96 °C, et de manière particulièrement préférée à une température de 63 °C.

5. Procédé selon la revendication 1, dans lequel le test de vieillissement est réalisé à une température dans la plage de 63 à 65 °C lorsque l'échantillon est de la bière, de 65 à 70 °C lorsque l'échantillon est du vin et à 60 °C lorsque l'échantillon est un jus.

6. Procédé selon l'une des revendications précédentes, dans lequel le test de vieillissement est réalisé à un pH qui se situe dans une plage qui s'étend d'un point de pH de 0,5 point de pH en dessous à 0,5 point de pH au-dessus du pH de l'échantillon et qui de manière particulièrement préférée correspond au pH de l'échantillon.

7. Procédé selon l'une des revendications précédentes, dans lequel le test de vieillissement est réalisé en présence d'éthanol en une concentration dans la plage de 0,01 à 20 % en volume, de préférence dans la plage de 0,01 à 10 % en volume, de manière davantage préférée dans la plage de 0,01 à 6,0 % en volume et de manière particulièrement préférée dans la plage de 0,01 à 3,0 % en volume.

8. Procédé selon l'une des revendications précédentes, dans lequel la réalisation de l'analyse à l'étape (c) comprend les étapes partielles suivantes :

    (c1) prélèvement d'un échantillon à mesurer à un moment déterminé ;
    (c2) enregistrement du spectre ESR de l'échantillon à mesurer.

9. Procédé selon la revendication 8, dans lequel la durée entre les étapes partielles (c1) et (c2) est ≤ 15 minutes, de préférence de 4 minutes.

10. Procédé selon l'une des revendications précédentes, dans lequel ledit procédé comprend un système entraînant la génération radicalaire, dans lequel le système entraînant la génération radicalaire est un système de type Fenton ou un système radiographique,
dans lequel un système de type Fenton est un système réactionnel dans lequel la réaction de type Fenton est initiée de façon ciblée dans des conditions expérimentales par l'association de péroxyde d'hydrogène et d'ions métalliques ($Fe^{2+}$) dans des solutions différentes et dans lequel, à l'aide du système radiographique, la génération radicalaire artificielle s'effectue par des rayons X ionisants.

11. Procédé selon l'une des revendications précédentes, comprenant l'analyse qualitative et/ou quantitative de l'effet d'un composé neutre d'un point de vue oxydatif, anti-oxydatif ou oxydatif sur le potentiel anti-oxydatif endogène de l'échantillon,
dans lequel le composé est choisi dans le groupe comprenant de l'hydrogène, $SO_2$, des produits réactionnels de Maillard, de l'acide ascorbique et d'autres vitamines, telles que la vitamine B ou la vitamine A, des ions métalliques, tels que $Fe^{2+}$ ou $Cu^+$, des composés phénoliques, tels que des acides phénolcarboxyliques, de préférence l'acide gallique, ou des flavonoïdes, des acides organiques, des protéines, des polypeptides, des acides aminés, des alcools, tels que l'éthanol, et des sels, tels que $CaCl_2$.

**12.** Procédé selon l'une des revendications précédentes,
dans lequel l'échantillon est dopé par $SO_2$ et un quotient $BAX_{(sp)}$ de l'augmentation du potentiel anti-oxydatif endogène EAP dans l'échantillon et de la teneur d'échantillon en $SO_2$ est déterminé selon la formule suivante

$$BAX_{(sp)} = \Delta\ EAP/\Delta\ teneur_{(sp)}\ en\ SO_2\ [min^{-1}/mg]$$

dans laquelle $\Delta$ EAP est la valeur EAP après dopage par $SO_2$ moins la valeur EAP avant dopage par $SO_2$, et dans laquelle $\Delta$ teneur en $SO_2$ est la teneur en $SO_2$ obtenue après dopage.

**13.** Procédé selon l'une des revendications 1 à 11, dans lequel un quotient BAX du potentiel anti-oxydatif endogène EAP total dans l'échantillon et de la teneur totale en $SO_2$ dans l'échantillon est déterminé selon la formule suivante :

$$BAX = EAP_{(total)}/teneur_{(totale)}\ en\ SO_2\ [min^{-1}/mg]$$

Figur 1

Figur 1A

Figur 1B

Figur 1C

Figur 2

## Effect of pH on Fenton's Reagent

EP 1 927 012 B1

**Figur 3**

Figur 4

Figur 5

# Figur 6

EP 1 927 012 B1

# Figur 8

Figur 9

Figur 9A

Figur 9B

# Figur 10.1

Figur 10B

Figur 10A

# Figur 10.2

Figur 10C

Figur 10D

# Figur 11

Figur 11B

Figur 11A

Figur 12

EP 1 927 012 B1

Figur 13

Orangen-Nektar (50 %)

ESR Signalintensität

EAP-Wert = 419 min

Zeit [min]

0  50  100  150  200  250  300  350  400  450  500  550  600  650  700  750  800

Figur 14

Apfelsinensaft naturtrüb (100%)

ESR Signalintensität

Zeit [min]

EAP-Wert = 930 min

Figur 15

Multivitamin - Mehrfruchtsaft (100%)

ESR Signalintensität

Zeit [min]

EAP-Wert = 927 min

EP 1 927 012 B1

Figur 16

Figur 17

Apfelsaft (100%) ohne Zuckerzusatz

ESR Signalintensität

EAP-Wert = n. n. (< 20 min)

Zeit [min]

EP 1 927 012 B1

Figur 18

Ruby Cabernet California 2004

ESR Signalintensität

EAP-Wert = 640 min

Zeit [min]

Figur 19

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **ANDEISEN M.L. et al.** *J. Agric. Food chem.,* 2001, vol. 49, 5232-5237
- **UCHIDA, M. ; ONO, M.** Improvement for Oxidative Flavor Stability of Beer - Role of OH-Radical in Beer Oxidation. *J. Am. Soc. Brew. Chem.,* 1996, vol. 54 (4), 198-204
- **UCHIDA, M. ; SUGA, S. ; ONO, M.** Improvement for Oxidative Flavor stability of Beer - Rapid Predicition Method for Beer Flavor Stability by Electron Spin Resonance Spectroscopy. *J. Am. Soc. Brew. Chem.,* 1996, vol. 54 (4), 205-211
- **STASKO, A. ; RAPTA, P. ; MALIK, F.** Charakterisierung der Bierstabilität mit Hilfe von Radikalfängern (eine EPR-studie). *Monatsschrift für Brauwissenschaft,* 2000, vol. 53 (1/2), 4-7
- **FORSTER, C. ; SCHWEIGER, J. ; NARZISS, L. ; BACK, W. ; UCHIDA, M. ; ONO, M. ; YANAGI, K.** Untersuchungen zur Geschmacksstabilität von Bier mittels Elektronenspinresonanz-Spektroskopie freier Radikale. *Monatsschrift für Brauwissenschaft,* 1999, vol. 52 (5/6), 86-93
- **FORSTER, C.** Die antioxidative Aktivität von Bier - eine neue Methode zur Verbesserung der Geschmacksstabilität. *Mitteilungen österreichisches Getränkeinstitut,* 1998, vol. 11/12, 132-139
- **YANAGI, K. ; ISHIBASHI, Y. ; OKA, K. ; UCHIDA, M.** Neue Methoden zur Beurteilung von Geschmacksstabilität. *Schaumeigenschaften und -stabilität von Bier, Brauwelt,* 1997, vol. 21/22, 841-859
- **ANDERSEN, M. L. ; OUTTRUP, H. ; SKIBSTED, H.** Potential Antioxidants in Beer Assessed by ESR Spin Trapping. *J. Agr. Food Chem.,* 2000, vol. 48 (8), 3106-3111
- **KANEDA, H. ; OSAWA, T. ; KAWAKISHI, S. ; MUNEKATA, M. ; KOSHINO,S.** Contribution of carbonyl-bisulfite adducts to beer stability. *J. Agr. Food Chem,* 1994, vol. 42, 2428-2432
- **KANEDA, H. ; MASACHIKA, T. ; OSAWA, T. ; KAWAKISHI, S. ; TAMAKI, T.** Behavior of Sulfites during Fermentation and Storage of Beer. *J. Am. Soc. Brew. Chem.,* 1996, vol. 54 (2), 115-120
- **WALTERS, M. T.** Natural antioxidants and flavour stability. *Ferment,* 1997, vol. 10 (2), 111-119
- **UCHIDA, M. ; ONO, M.** Technological Approach to Improve Beer Flavor Stability: Analysis of the Effect of Brewing Processes on Beer Flavor Stability by the Electron Spin Resonance Method. *J. Am. Soc. Brew. Chem.,* 2000, vol. 58 (1), 8-13

- **KANEDA, H. ; KANO, Y ; OSAWA, T. ; RAMARATHNAM, N. ; KAWAKISHI, S. ; KAMADA, K.** Detection of Free Radicals in Beer Oxidation. *Journal of Food Science,* 1988, vol. 53, 885-888
- **KUNZ, T. ; STEPHAN, A. ; METHNER, F.J. ; KAPPL, R. ; HÜTTERMANN, J.** Grundlegendes zur Elektronenspinresonanz-Spektroskopie (ESR) und Untersuchungen zum Zusammenhang zwischen oxidativer Bierstabilität und dem SO2-Gehalt. *Monatsschrift für Brauwissenschaft,* 2002, vol. 55 (7/8), 140-153
- **WACKERBAUER, K. ; HARDT, R.** Radikalreaktionen und die Geschmacksstabilität des Bieres. *Brauwelt,* 1996, vol. 40/41, 1880-1888
- **BACK, W. ; FORSTER, C. ; KROTTENTHALER, M. ; LEHMANN, J. ; SACHER, B. ; THUN, B.** Neue Forschungserkenntnisse zur Verbesserung der Geschmacksstabilität. *Brauwelt,* 1997, vol. 38, 1677-1692
- **KUNZ, T.** Untersuchungen zur oxidativen Bierstabilität mittels Elektronenspinresonanz (ESR). *Diplomarbeit,* 2002
- **ANDERSEN, M. L. ; SKIBSTED, L. H.** Electron Spin Resonance Spin Trapping Identification of Radicals Formed during Aerobic Forced Aging of Beer. *J. Agr. Food Chem.,* 1998, vol. 46, 1272-1275
- **KUNZ, T. ; KAPPL, R. ; METHNER, F. J. ; STEPHAN, A. ; HÜTTERMANN, J.** *Einfluss physiko-chemischer Parameter auf die Lag-Time Messung*
- **BISHOP, D. ; STERN, G. ; FLEISCHMANN, M. ; MARSHALL, L.** Hydrogen Peroxide Catalytic Oxidation of Refractory Organics in Municipal Waste Water. *I&EC Process Design and Development,* 1968, vol. 7, 110-117
- **MILLERO, F. J. ; SOTOLONGO, S. ; STADE, D. J. ; VEGA, C. A.** Effect of Ionic Interactions on the Oxidation of Fe (II) with H2O2 in Aqueous Solutions. *Journal of Solution Chemistry,* 1991, vol. 20 (11), 1079-1092
- Determination of antioxidants in brewing: Some aspects about the use of selected chemical and physical assays. **STEPHAN, A. ; BIES, A ; KUNZ, T. ; METHNER, F. J.** European Brewery Convention, Monograph 31, Symposium Flavour and Flavour Stability. Fachverlag Hans Karl, 2001

- **FRANZ, O. ; BACK, W.** Erfahrungen zur Messung von freien Radikalen mittels Elektronenspinresonanz-Spektrometer in der Brauerei. *Monatsschrift für Brauwissenschaft,* 2002, vol. 55 (7/8), 156-162

- **POU, S. ; RAMOS C. L. ; GLADWELL, T. ; RENKS, E. ; CENTRA, M. ; YOUNG, D. ; COHEN, M. S. ; ROSEN, G. M.** A Kinetic Approach to the Selection of a Sensitive Spin Trapping System for the Detection of Hydroxyl Radical. *Analytical biochemistry,* 1994, vol. 217, 76-83